Europäisches Patentamt

European Patent Office

Office européen des brevets

(19)

(11) Veröffentlichungsnummer : **0 051 567**
**B1**

(12) **EUROPÄISCHE PATENTSCHRIFT**

(45) Veröffentlichungstag der Patentschrift :
25.03.87

(21) Anmeldenummer : 81810440.8

(22) Anmeldetag : 03.11.81

(51) Int. Cl.⁴ : **G 03 B 41/00**

(54) Anordnung zur automatischen Justierung mindestens eines Gegenstandes.

(30) Priorität : 03.11.80 DD 224904

(43) Veröffentlichungstag der Anmeldung :
12.05.82 Patentblatt 82/19

(45) Bekanntmachung des Hinweises auf die Patenterteilung : 25.03.87 Patentblatt 87/13

(84) Benannte Vertragsstaaten :
CH DE FR GB LI NL

(56) Entgegenhaltungen :
EP-A- 0 005 462
DE-A- 2 930 979
US-A- 3 029 348
US-A- 3 671 748
US-A- 3 744 914
US-A- 3 984 186

(73) Patentinhaber : Jenoptik Jena G.m.b.H.
Carl-Zeiss-Strasse 1
DDR-6900 Jena (DD)
DE NL
VEB Carl Zeiss Jena
Carl-Zeiss-Strasse 1
DDR-6900 Jena (DD)
CH FR GB LI

(72) Erfinder : Schorcht, Adelbrecht
Fritz-Reuter-Strasse 48
DDR-6900 Jena (DD)
Erfinder : Klingenfeld, Dietmar
Wenigenjenaer Ufer 4b
DDR-6900 Jena (DD)
Erfinder : Hesse, Reiner
Hermann-Matern-Strasse 3
DDR-6902 Jena-Lobeda (DD)
Erfinder : Dastis, Rainer
Werner-Seelenbinder-Strasse 27
DDR-6902 Jena-Lobeda (DD)
Erfinder : Linz, Voiker
Heinrich-Rau-Strasse 18
DDR-6902 Jena-Lobeda (DD)

(74) Vertreter : Tschudi, Lorenz et ai
Bovard AG Patentanwälte VSP Optingenstrasse 16
CH-3000 Bern 25 (CH)

EP 0 051 567 B1

Jouve, 18, rue St-Denis, 75001 Paris, France

## Beschreibung

Die Erfindung betrifft eine Anordnung zur automatischen Justierung eines Gegenstandes, beispielsweise einer Halbleiterscheibe oder einer Schablone, gegenüber einem lichtelektrischen Mess- und Abtastsystem oder zur Justierung der beiden Gegenstände zueinander und zum Mess- und Abtastsystem, gemäss dem Oberbegriff des Patentanspruches 1, insbesondere bei der schrittweisen Projektionslithographie für die Herstellung von Halbleiterstrukturen in Planartechnologie.

Eine solche Anordnung ist aus der DE-A-2 523 858 vorbekannt.

Die Justierung erfolgt anhand von Justiermarken auf den Gegenständen mit mindestens einer Symmetrieachse. Die Justiermarken werden von einer Litchtquelle beleuchtet und durch optische Systeme auf die Abtastebene des lichtelektrischen Mess- und Abtastsystems abgebildet. Dessen Bildsignal wird elektronisch verarbeitet, durch ein Rechenwerk ausgewertet und in Steuersignale für mindestens eines die Justierung besorgendes Stellglied umgesetzt.

Die Erfindung ist auch für andere Symmetrieabgleichsysteme anhand von Marken verwendbar, wie z. B. bei der Zweistrahlphotometrie, bei der Abgleichblenden wie die Marken wirken können.

Gegenwärtig sind verschiedene Anordnungen zur automatischen Justierung zweier Gegenstände, z. B. in der Fotolithographie zur Ausrichtung von Halbleiterscheibe und Schablone zueinander, bekannt. Hierbei werden die Justiermarken der beiden Gegenstände gemeinsam auf ein fotoelektrisches Meß- und Abtastsystem abgebildet, die entsprechenden Signale z. B. durch Rechner verarbeitet und Steuersignale für Stellmotore, die einen oder beide Gegenstände bewegen, erzeugt. Dabei werden jeweils die beiden Gegenstände nacheinander zum Meß- und Abtastsystem justiert.

Die Bildabtastung erfolgt mittels Fernsehkamera (DE-A-2 523 858), Schwingspiegel (DD-B-108 620) oder Schlitzträger, wie rotierende Schlitz- oder Lochblenden, und die Bildsignalauswertung erfolgt entweder durch Photometrie (vorwiegend für Flächenmarken) oder durch Bildanalyse (vorwiegend für Kantenmarken).

Gegenwärtig sind verschiedene Arten von Marken auf den Halbleiterscheiben in Gebrauch. Flächenmarken sind solche, die im Auflicht als dunkle Flächen im hellen Umfeld erscheinen. Kantenmarken werden meist durch Ätzungen hergestellt. Sie erscheinen im Auflicht nur an den Böschungen der Ätzungen als dunkle Kanten. Geätzte Striche werden so immer als Doppelmarke erkannt. Aus der Zweistrahlphotometrie ist die wechselseitige Unterbrechung der beiden Lichtströme durch eine rotierende Lochblende (Chopper) bekannt, wobei diese Lochblende z. B. Lichtschranken zur Umschaltung bzw. Zuordnung der aus den Lichtströmen gewonnenen Signale zum jeweils abgetasteten Strahlengang (Kanal) besitzt. (Taschenbuch Feingerätetechnik, Band 1, Abschnitt 14 « Optische Meßtechnik », insbesondere 14.2.2. « Photometrische Meßverfahren », Verlag Technik Berlin 1968).

Bei der Ausrichtung der beiden Gegenstände in der Fotolithografie werden analog dazu verschieden gestaltete Schlitzträger zur Bildabtastung verwendet, die ebenfalls separate Bezugs- oder Steuersignale erzeugende Öffnungen zur Kanalumschaltung besitzen können, welche durch Lichtschranken abgetastet werden (DE-A-2 160 282). Jede der bekannten Anordnungen erlaubt nur die Anwendung für eine Markenart, sie ist also entweder auf die Strukturerkennung oder die Photometrie festgelegt. Ebenso gestatten die bekannten Anordnungen nicht eine Justierung zweier Gegenstände zueinander und eines Gegenstandes zu einem Meß- und Abtastsystem mit gemeinsamen Mitteln.

Ziel der Erfindung ist es, eine hochgenaue, dabei schnellstmögliche Justierung einer Halbleiterscheibe und einer Schablone relativ zueinander unter wahlweiser Benutzung der unterschiedlichen Justiermarken sowohl nach den dadurch beeinflußten Lichtströmen innerhalb des Justiermarkenbildes oder nach der Lage ihrer Struktur bei weitestgehender Vermeidung systematischer Fehler zu ermöglichen. Dabei sollen die realen Bedingungen wie die gegebenen Lichtverhältnisse mit dem damit gegebenen Signal-Rauschverhalten berücksichtigt werden. Es soll eine Erhöhung der Genauigkeit der Justierung und der Produktivität erzielt werden.

Der Erfindung liegt die Aufgabe zugrunde, eine Anordnung zur Erzielung eines Symmetrieabgleiches zu finden, wobei für die wahlweise Auswertung eines Bildes nach Lichtströmen oder Struktur ein Signal für eine Regelabweichung gebildet wird, um einen Regelkreis anzusteuern, der eine Symmetrie des Bildes zu einer ortsfesten Achse herstellt.

Die Aufgabe läßt sich beschränken auf eine einzige Bewegungsrichtung des Überdeckungssystemes, welches üblicherweise zwei translatorische Bewegungen in x- und y-Richtung und eine rotatorische um den Winkel $\varphi$ einschließt, die aber wesensgleich sind für diese Aufgabe. Insbesondere stellt sich diese Aufgabe bei Halbleiterscheiben, die als Justiermarken Flächen- oder Kantenmarken tragen, welche als Struktur eine Symmetrieachse besitzen, die zu einer ortsfesten Achse der Abtastebone des lichtelektrischen Meß- und Abtastsystems der Anordnung zur automatischen Justierung bei der schrittweisen Projektionslithografie parallel ausgerichtet ist. Bei diesen Justiermarken sollen für eine universelle Arbeitsmöglichkeit mit den beiden Markenarten entweder der Ort der Struktur oder die durch die Justiermarken beeinflußten Lichtströme mit Hilfe von weitgehend gleichen Mitteln bestimmt werden.

Verallgemeinert ist eine solche Halbleiterscheibe ein erster Gegenstand, der die genannten Marken trägt, so daß bei ähnlich gelagerten Aufgaben ein entsprechender Gegenstand mit solchen Marken versehen und justiert werden kann.

Erfindungsgemäß wird die Aufgabe dadurch gelöst, daß ein erstes Mittel vorhanden ist, welches in der Abtastebene eines lichtelektrischen Meß- und Abtastsystems eine ersten und einen zweiten, durch eine ortsfeste Achse getrennten Bildausschnitt wirksam werden läßt, die im wesentlichen gleich ausgebildet, zur ortsfesten und optischen Achse einander gegenüber- und zur Symmetrieachse der Justiermarken parallelliegend angeordnet sind. Ein zweites Mittel im lichtelektrischen Meß- und Abtastsystem ermöglicht eine periodische Bildabtastung senkrecht zur ortsfesten Achse und ist mit einem Taktgenerator für die Zeitbasis verbunden.

Durch einen mit dem lichtelektrischen Meß- und Abtastsystem verbundenen Schaltzeitpunktdetektor wird ein erster, zweiter und dritter Schaltzeitpunkt vorgegeben, zwischen denen die beiden Bildausschnitte abwechselnd zur Bildsignalerzeugung benutzt werden. Der Schaltzeitpunktdetektor ist Bestandteil einer Kanalsteuereinrichtung.

Sowohl das Meß- und Abtastsystem als auch die Kanalsteuereinrichtung sind ausgangsseitig verbunden mit einer sequentiellen Bildsignalverarbeitungseinrichtung und das Rechenwerk enthält mindestens einen in zwei Funktionsgruppen betreibbaren Speicher und mindestens eine Arithmetikeinrichtung, deren Ausgang das Steuersignal für wenigstens ein Stellglied zur Justierung wenigstens eines Gegenstandes zu liefern gestattet. Es wird also ein Bild der Justiermarken eines Gegenstandes mit den Symmetrieeigenschaften in der Abtastebene des lichtelektrischen Meß- und Abtastsystems mittels des optischen Abbildungssystems erzeugt. Das Abtastsystem kann je nach Zweckmäßigkeit eine mechanische Abtastvorrichtung, wie z. B. eine bekannte rotierende Loch- oder Schlitzscheibe mit dem jeweiligen Loch oder Schlitz als Abtastelement, oder eine elektronische Vorrichtung, wie eine Fernsehkameraröhre z. B. vom Vidicontyp mit dem Abtastelektronenstrahl als Abtastelement, oder eine Imagedissectorröhre mit dem Diaphragma als Abtastelement oder eine CCD-Struktur mit einem Empfängerelement als Abtastelement sein. Zur Sicherung der möglichen Genauigkeit für die angestrebte wahlweise mehrfache Auswertemöglichkeit des Bildes wird ein Zweistrahlverfahren geschaffen. Und zwar wird das Bild in der Abtastebene mittels der Funktion einer Maske als erstes Mittel mit zwei zur ortsfesten Achse symmetrischen Fenstern zur Erzeugung von Bildausschnitten geteilt.

Diese Fenster sind gleich oder ähnlich mit einer Dimensionierung der Fensterbegrenzung nach gegebenen Toleranzverhältnissen, so daß reale oder funktionelle Maskenfenster entstehen, die zweckmäßig durch einen Mittelsteg ohne Bildinhalt getrennt sind.

Reale Maskenfenster sind geeignet für die mechanische Abtastvorrichtung. Funktionelle Maskenfenster sind möglich durch elektronische Ausblendung des Signals außerhalb der nun elektronischen Fensterbegrenzung. Durch den Mittelsteg wird eine Unabhängigkeit von Toleranzen der anschließend behandelten Kanalumschalteinrichtung erreicht.

Zur Ausbildung des Zweistrahlverfahrens mittels der Kanalumschalteinrichtung wird eine Zuordnung eines jeden Maskenfensters zu je einem Bildsignal bewirkt, wobei der Bildsignalfluß parallel oder vorzugsweise seriell (zeitlich) erfolgen kann.

Zur Vermeidung von Fehlern der Abtasteinrichtung wird unter Einbeziehung von Toleranzen einschließlich der Fenstertoleranzen die Zuordnung der Steuersignale für Schaltzeitpunkte der Kanalumschalteinrichtung zu den Maskenfenstern in der Art durchgeführt, daß diese sich außerhalb der möglichen Lagen der Fensterbegrenzungen befinden, und daß ein erster und dritter Schaltzeitpunkt jeweils symmetrisch zur ortsfesten Achse und außerhalb der äußeren Fensterbegrenzungen festgelegt und ein zweiter Schaltzeitpunkt identisch mit der ortsfesten Achse ist.

Hierdurch entstehen ähnlich wie bei den bekannten Zweistrahlphotometerverfahren, jedoch hier auch für die Strukturauswertung, zwei Zeitabschnitte, und zwar einer vor und einer nach der ortsfesten Achse, aber nun so, daß abgedeckt durch die Maske die Signalabschnitte immer innerhalb der Schaltabschnitte der Kanalumschaltung liegen, wodurch keine zum falschen Kanal gehörende Signalanteile übertragen werden können.

Zweckmäßig werden die der Erzeugung der Steuersignale der Kanalumschalteinrichtung dienenden Mittel, wie z. B. die Lichtschlitze für eine Lichtschranke, ebenfalls auf dem Bauteil mit den Maskenfenstern aufgebracht, um Fehler zwischen der Lage der Lichtschlitze und der Fenster zu vermeiden.

Zur Gewinnung des Signals für die Regelabweichung für die Ansteuerung eines Regelkreises für den Symmetrieabgleich aus den Signalinformationen der Signalabschnitte wird mittels eines Rechenwerkes eine Rechenoperation vorgenommen, um weitgehend unabhängig von der absoluten Signalhöhe die Regelabweichung zu bilden, und zwar nach jedem einzelnen Abtastzyklus zur Vermeidung der Zeitabhängigkeit bzw. -verzögerung, die bei bekannten Lösungen auftritt und außerdem, um Toleranzen des Abtastelementes, z. B. des Schlitzes der rotierenden Schlitzscheibe, der für je einen Abtastzyklus gilt, unwirksam zu machen, und zwar so, daß für alle Auswertemöglichkeiten des Bildes aus der Bildsignalinformation eines ersten Schaltabschnittes, liegend zwischen erstem und zweitem Schaltzeitpunkt, ein Wert A gewonnen und dividiert wird durch einen Wert C, und daß ebenso für einen zweiten Schaltabschnitt zwischen zweitem und drittem Schaltzeitpunkt ein Wert B gewonnen und dividiert durch einen Wert D zu einem Wert für die Regelabweichung als Differenz der beiden Quotienten und multipliziert mit einem Gerätefaktor K gebildet wird zu

$$X = K(A/C - B/D),$$

wobei es zunächst belanglos ist, ob das Rechenwerk mit analogen oder digitalen Werten arbeitet.

Im weiteren wird diese Rechenoperation zugeschnitten auf die Betriebsart des Symmetrieabgleiches nach Auswertung der Lichtströme als Vergleich zwischen zwei Maskenfenstern durch Integration des Bildsignals, welches hier zweckmäßig dem Lichtstrom proportional ist, mittels eines Integrators innerhalb des ersten Schaltabschnittes zum Wert A und innerhalb des zweiten Schaltabschnittes zum Wert B.

So wird durch die Wirkung der Maskenfenster die tatsächliche Integration bis auf den meist vernachlässigbaren Dunkelstrom des photoelektrischen Wandlers trotz der außerhalb liegenden Schaltzeitpunkte nur innerhalb des Maskenfensters wirksam.

Für den häufigen Fall, daß z. B. beim Abgleich mittels Flächenmarken die Werte A und B gegensinnig verlaufen, wird C = D = A + B geschaltet.

Für den Fall der reinen Photometrie mit einem für den Abgleich fixen Meßstrahlengang wird nur der Vergleichstrahlengang abgeglichen. Dafür wird C = D = A oder B geschaltet, wobei der beim Symmetrieabgleich konstant bleibende Wert einzusetzen ist.

Für das angestrebte Überdeckungssystem ist dieser Fall jedoch ohne Bedeutung, so daß die Regelabweichung allgemein zu X = K(A — B/A + B) und für die einfachste Lösung X = K(A — B) gilt.

Die sequentielle Bildverarbeitungseinrichtung bereitet die anfallenden Bildsignale in der Reihenfolge A — B — A — B vor zur Verarbeitung für das Rechenwerk. Die aus dem Rechenwerk gewonnene normierte Größe ist Eingangsgröße der Regelabweichung für die erste Ansteuer- und Antriebseinrichtung zur Ausrichtung des ersten Gegenstandes.

Somit gelingt es, mit im wesentlichen gleichen Mitteln neben den Flächenmarken entweder in photometrischer als auch in strukturempfindlicher Auswertung, die technologisch vorteilhaften Kantenmarken mit hoher Genauigkeit und Geschwindigkeit zwecks Symmetrieabgleich zu erfassen.

Während es mit der beschriebenen ersten Anordnung im Rahmen des Überdeckungssystems darum geht, den Symmetrieabgleich eines Gegenstandes aber noch in Bezug auf das Meßsystem zu schaffen, so ist es Aufgabe der erweiterten Anordnung, die Zuordnung zweier flächenhafter Gegenstände nur zueinander, bei weitgehender Unabhängigkeit von der Lage der Gegenstände zum Meßsystem zu bewerkstelligen.

Die Lösung geht davon aus, daß der zweite Gegenstand die Funktion des Meßsystems des ersten verfahrens übernimmt, wie im folgenden dargelegt wird.

Hierbei ist insbesondere der erste Gegenstand eine Halbleiterscheibe mit Flächen- oder Kantenmarken. Der zweite Gegenstand ist dann eine Schablone mit der für die Halbleiterherstellung vorgesehenen Struktur mit Justiermarken, ebenfalls mit den Merkmalen einer Schablone als Muster von lichtundurchlässigen und lichtdurchlässigen Flächen.

Ein bekanntes zweites Abbildungssystem befindet sich zwischen erstem und zweitem Gegenstand, welches eingerichtet ist für Auflichtbeleuchtung des ersten Gegenstandes und einen Strahlenteiler zum Aufteilen in einen Beleuchtungs- und einen Abbildungsstrahlengang besitzt, der seinerseits das erste Abbildungssystem einschließt. Über den Beleuchtungsstrahlengang werden die Justiermarken des zweiten Gegenstandes bzw. der Schablone in die Ebene der Justiermarken des ersten Gegenstandes abgebildet und ergeben so nach den Abbeschen Komparatorprinzip ein Bild für die Lage der beiden Justiermarken zueinander.

Dieses Bild der Justiermarken vom zweiten Gegenstand und die Justiermarken vom ersten Gegenstand werden übver den Abbildungsstrahlengang, über den Strahlenteiler und das erste Abbildungssystem in die Abtastebene des lichtelektrischen Meßsystems abgebildet und damit wäre dieses Abbild so schon verarbeitbar, jedoch in Bezug auf das Meßsystem.

Zwecks weitgehender Trennung von der Abhängigkeit zum Meßsystem und der strikten Durchführung des Zweistrahlverfahrens wird in ähnlicher Weise eine Zweiteilung des Abbildes der Justiermarken durch Ausbildung der Schablonenmarken jeweils in der Form von zwei Fenstern, die symmetrisch zu einer Spiegelachse und mit Toleranz parallel zur ortsfesten Achse und so zu einem Schablonenfensterpaar mit Mittelsteg ohne Bildinhalt gestaltet sind, daß bei gegebenem Toleranzfeld das Schablonenfensterpaar immer innerhalb der Begrenzung des zugehörigen Maskenfensterpaares zu liegen kommt.

So ist zum einen durch die Verwendung von Schattenbildern gewährleistet, daß nur ein Schwellenwert notwendig und das Komparatorprinzip zum Erreichen der möglichen Genauigkeit durchgängig einzuhalten ist. Zum anderen ist durch die Gestaltung der Schablonenjustiermarken und des Strahlenganges die Funktion des Meßsystems in den zweiten Gegenstand verlagert worden, so daß unabhängig und in kürzester Zeit die Ausrichtung der beiden Gegenstände zueinander erfolgen kann. Die Regelgröße, die damit gewonnen wird, ist die Eingangsgröße für die erste Ansteuer- und Antriebseinrichtung für die Ausrichtung des ersten Gegenstandes. Das automatische Ausrichten zweier flächenhafter Gegenstände zueinander, insbesondere zwecks Überdeckung der Halbleiterscheibe zur Schablone setzt voraus, daß sich die Schablone im Einfangbereich für die automatische Überdeckung befindet und sie sich zur Absicherung günstiger optischer Abbildungsverhältnisse auch in einem gegebenen Toleranzbereich befindet. Das ermöglicht, daß vorteilhaft mit weitgehend gleichen Mitteln auf der Grundlage der Strukturerkennung der Justiermarken eine jeweils neue Schablone zum Meßsystem ausgerichtet werden kann.

Eine Voraussetzung zur Lösung dieser Aufgabe ist es, daß die Schablone durch eine ähnlich ansteuerbare Antriebseinrichtung wie für die Halbleiterschéibe ausrichtbar ist in Verbindung mit einer Umschaltvorrichtung für die Signale der Regelabweichung.

Es wird davon ausgegangen, daß die Justiermarkenausbildung der Schablone in Form eines Fensterpaares die Voraussetzung bietet für deren Ausrichtung zum Maskenfensterpaar der Abtastvorrichtung.

Die Lösung der Aufgabe wird ermöglicht durch die Aufteilung des Bildes in Teilsummen bzw. Teilstrecken, und zwar dadurch, daß hierfür die jeweils äußeren, durch die Schablonenmarkenbegrenzungen abgedeckten Teilstrecken als Kriterium für den Symmetrieabgleich herangezogen werden. So wird die Regelabweichung gebildet mittels der Schaltung $A = A_1$, $B = B_n$, $C = D = A_1 + A_2 + \cdots + A_m + B_1 + B_2 + \cdots B_n$, wobei sich ein normales Justiermarkenbild überlagern kann.

Dann wird das Signal für die Regelabweichung umgeschaltet auf den Eingang der zweiten Ansteuer- und Antriebseinrichtung für die Schablone, so daß dieser Regelkreis geschlossen ist.

Für den Fall, daß das Justiermarkenbild für die Ausrichtung der Halbleiterscheibe zur Schablone zufällig so ungünstig liegt, daß die Regelgröße für den vorliegenden Fall beeinflußt wird, so wird wechselweise auf die Betriebsart für den Symmetrieabgleich nach der Struktur umgeschaltet, damit sowohl die Ausrichtung der Halbleiterscheibe zur Schablone und der Schablone zur Abtastvorrichtung optimal erfolgt.

Ausführungsbeispiel des Erfindung wird nachstehend anhand der schematischen Zeichnungen erläutert. Es zeigen :

Figur 1 einen Teil eines Ausführungsbeispiels,

Figur 2 den anderen Teil des Ausführungsbeispiels gemäß Fig. 1 zur Signalgewinnung von Justiermarkenbildern,

Figur 3 die zugehörigen Justiermarkenbilder,

Figur 4 ein zweites Ausführungsbeispiel zur Signalgewinnung mit einer Fernsehkamera,

Figur 5 denjenigen Teil der Anordnung, der zur Verarbeitung von Bildsignalen dient,

Figur 6 ein drittes Ausführungsbeispiel mit einer mechanischen Abtastung von Justiermarkenbildern,

Figur 7 denjenigen Teil des dritten Ausführungsbeispiels, der zur Steuersignalgewinnung mit drei lichtelektrischen Empfängern dient,

Figur 8 denjenigen Teil des dritten Ausführungsbeispiels, der zur Steuersignalgewinnung mit einem lichtelektrischen Empfänger dient,

Figur 9 eine zweite Ausführungsform zur Steuersignalgewinnung gemäß Fig. 8.

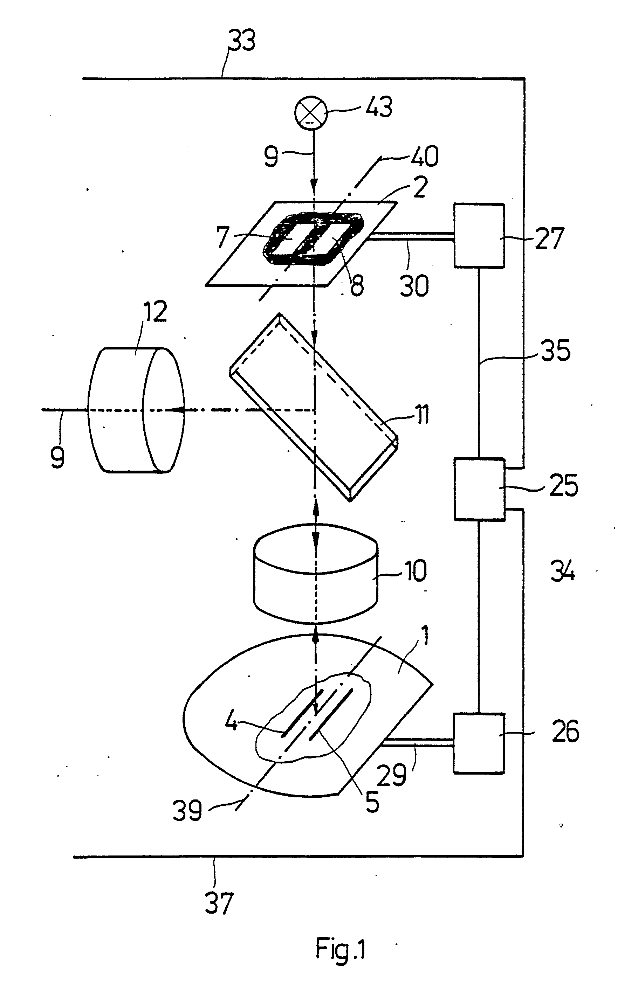

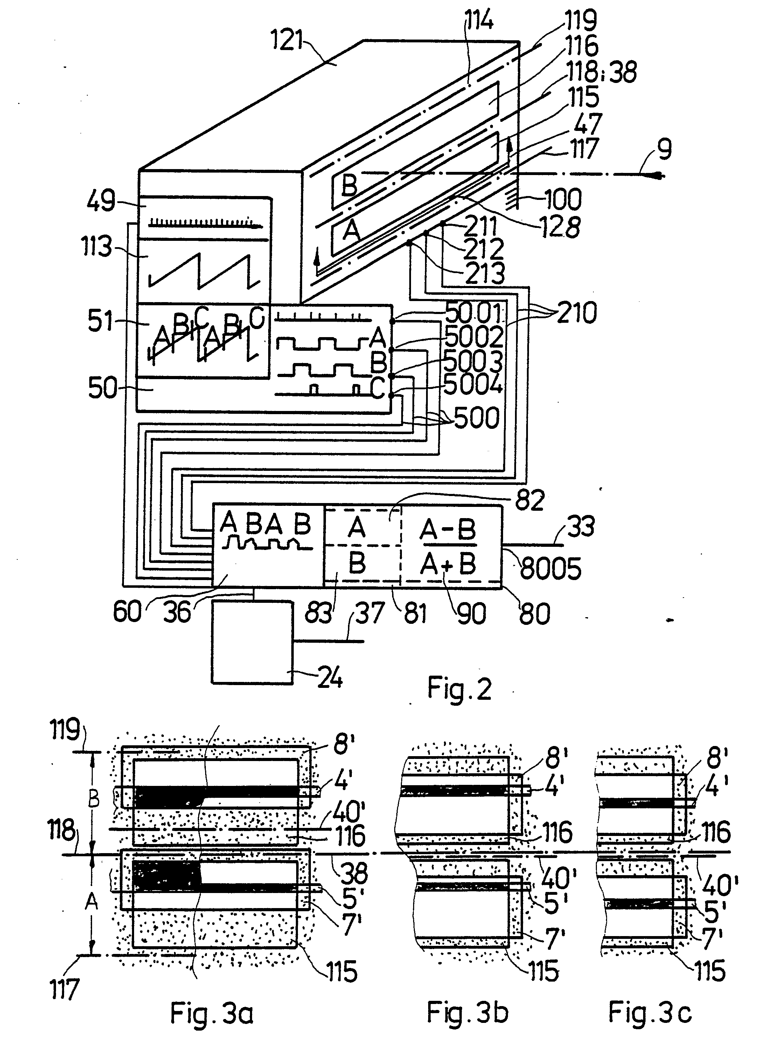

Gemäß Fig. 1 und 2 trägt eine Halbleiterscheibe 1 (erster Gegenstand) vergrößert dargestellte Justiermarken 4, 5. Längs einer optischen Achse 9 sind ein erstes Objektiv 10, ein halbdurchlässiger Spiegel 11, eine Schablone 2 (zweiter Gegenstand) und eine Lichtquelle 43 angeordnet. Die Schablone 2 weist vergrößert dargestellte Justiermarken 7, 8 in Form von rechteckigen lichtdurchlässigen Bereichen (Schablonenfenstern) symmetrisch zu einer Schablonenfensterachse 40 auf.

Ein zweites Objektiv 12 befindet sich im Abbildungsstrahlengang für die Halbleiterscheibe 1.

Ein erstes Stellglied 26 und ein zweites Stellglied 27 sind mit mechanischen Verbindungen 29, 30 zur Justierung der beiden Gegenstände 1 und 2 mit diesen gekoppelt. Die Stellglieder 26, 27 sind über Signalleitungen 34, 35 mit einer Antriebsartenweiche 25 verbunden und diese ist wiederum über eine Signalleitung 33 mit einem Ausgang 8005 eines Rechenwerkes 80 und über eine Signalleitung 37 mit einer Betriebsartenwahleinrichtung 24 (Figur 2) verbunden. Im Abbildungsstrahlengang mit der optischen Achse 9 befindet sich in einer Abtastebene 100 ein lichtelektrisches Meß- und Abtastsystem 121 mit einem ersten Mittel 114 zur Erzeugung von einem ersten Bildausschnitt 115 und einem zweiten Bildausschnitt 116. Durch strichpunktierte Linien sind ein erster Schaltzeitpunkt 117, ein zweiter Schaltzeitpunkt 118 und ein dritter Schaltzeitpunkt 119 charakterisiert, zwischen denen die Bildausschnitte 115 und 116 zur Bildsignalerzeugung benutzt werden. Ein Schaltabschnitt A liegt zwischen dem ersten und zweiten Schaltzeitpunkt 117, 118, ein Schaltabschnitt B liegt zwischen dem zweiten und dritten Schaltzeitpunkt 118, 119 und ein Schaltabschnitt C liegt zwischen dem dritten und dem ersten Schaltzeitpunkt 119, 117.

Dabei fällt der erste Schaltzeitpunkt 118 mit einer ortsfesten Achse 38 zusammen.

Ein körperlich vorhandenes oder durch elektronische Schaltungen gewonnenes Abtastelement 128 hat eine Laufrichtung 47 und bewegt sich nacheinander über den Schaltzeitpunkt 117, den Bildausschnitt 115, den Schaltzeitpunkt 118, den Bildausschnitt 116 und den Schaltzeitpunkt 119. Im lichtelektrischen Meß- und Abtastsystem 121 ist ein zweites Mittel 113 zur periodischen Bildabtastung enthalten. Mit diesem intern verbunden ist sowohl ein Taktgenerator 49 als auch ein Schaltzeitpunktdetektor 51, der Bestandteil einer Kanalsteuereinrichtung 50 ist. Eine sequentielle Bildverarbeitungseinrichtung 60 steht in Verbindung mit dem Rechenwerk 80 oder kann auch dessen Bestandteil sein.

Das Rechenwerk 80 enthält Speicher 81 mit einer ersten 82 und einer zweiten 83 Funktionsgruppe für Werte A und B sowie Arithmetikeinrichtungen 90. Die sequentielle Bildverarbeitungseinrichtung 60 und damit auch das Rechenwerk 80 sind mit dem lichtelektrischen Meß- und Abtastsystem 121 über Bildsignalleitungen 210 mit der Kanalsteuereinrichtung 50 über Betriebssteuerleitungen 500 und mit der Betriebsartenwahleinrichtung 24 über eine Signalleitung 36 verbunden.

In Fig. 3a, b, c sind Bilder 4', 5' der Justiermarken 4, 5 und der Schablonenfenster 7', 8' mit der Schablonenfensterachse 40' in der Abtastebene 100 des lichtelektrischen Meß- und Abtastsystems 121 dargestellt. In der linken Hälfte der Figur 3a sind die Bilder 4', 5' der Justiermarken 4, 5 als Flächenmarken ausgebildet und in der rechten Hälfte als Kantenmarken.

Die durch die Lichtquelle 43 beleuchteten Schablonenfenster 7, 8 werden durch das erste Objektiv 10 in die Ebene der Justiermarken 4, 5 der Halbleiterscheibe 1 abgebildet und gemeinsam mit diesen über das erste Objektiv 10, den halbdurchlässigen Spiegel 11 und das zweite Objektiv 12 in die Abtastebene 100 des lichtelektrischen Meß- und Abtastsystems 121 abgebildet.

Fig. 3a zeigt diese Abbildungen für einen unabgeglichenen Zustand sowohl der Halbleiterscheibe 1 als auch der Schablone 2, z. B. zu Beginn des Abgleichsvorganges. Die Bilder der Schablonenfenster 7', 8' liegen so unsymmetrisch (in der Fig. 3a nach oben verschoben) zur ortsfesten Achse 38, daß sie sich zum Teil außerhalb der Bildausschnitte 115, 116 befinden.

Die Bilder 4', 5' der Justiermarken der Halbleiterscheibe 1 liegen ebenfalls unsymmetrisch zur ortsfesten Achse 38.

Innerhalb der beiden Bildausschnitte 115, 116 ergeben sich so beleuchtete und unbeleuchtete Bereiche. Dabei sind die hellen Bereiche diejenigen, durch welche ungehindert Licht von der Lichtquelle 9 durch die Schablonenfenster 7 und 8 nach Reflexion der Halbleiterscheibe 1 über die optischen Abbildungssysteme 10, 12 auf die Bildausschnitte 115 und 116 gelangt.

Die punktierten Bereiche sind diejenigen innerhalb derer eine Abschattung durch die Schablonenfenster 7, 8 erfolgt oder das Licht außerhalb der Bildausschnitte 115, 116 auf die Abtastebene 100 trifft. Innerhalb der punktierten Bereiche sind die Konturen der Bildausschnitte 115 und 116 sowie der Justiermarkenbilder 4', 5' der Halbleiterscheibe 1 und der Bilder der Schablonenfenster 7', 8' durchgehend eingezeichnet, obwohl sie zur Bildsignalbildung nicht beitragen.

Beim Abtasten der gezeichneten Bilder durch das Abtastelement 128, welches sägezahnartig durch das zweite Mittel 113 periodisch bewegt wird, fällt in den abgeschatteten Bereichen kein Licht auf einen der nachfolgend genannten lichtelektrischen Wandler.

In den hellen Bereichen entspricht die elektrische Bildsignalamplitude dem Lichtstrom.

Die Signalform korrespondiert mit der gewählten Art des lichtelektrischen Meß- und Abtastsystems 121, das als Fernsehkameraröhre, beispielsweise von Vidikon-Typ, oder Imagedissektorröhre, oder Festkörperanordnung beispielsweise als CCD-Struktur, ausgebildet sein kann. In diesen Fällen ist die Ausgangsgröße ein analoger elektrischer Strom. Das Bildsignal ist amplitudenmoduliert durch die Bildstruktur und liegt an einem Ausgang 211 des lichtelektrischen Meß- und Abtastsystems 121 an. Es kann auch über einen Analog-Digitalwandler in binärkodierter Form an einem Ausgang 212 des lichtelektrischen Meß- und Abtastsystems 121 vorliegen.

Zur mechanischen Abtastung des Bildes eignet sich ein Photovervielfacher, der als Photonenzähler betrieben werden kann. Möglich ist dies auch beim Imagedissektor. Das dazu gehörende Bildsignal ist eine Impulsfolge, die proportional dem Lichtstrom ist. Die Signalform liegt so in Pulsmodulation an einem Ausgang 213 des lichtelektrischen Meß- und Abtastsystems 121 vor.

Die Wirkungsweise soll anhand der Amplitudenmodulation verfolgt werden. Das Bildsignal erreicht nacheinander für die Schaltabschnitte A und B die sequentielle Bildverarbeitungseinrichtung 60. Um die Bildsignale für die Schaltabschnitte A und B getrennt verarbeiten zu können, werden Steuersignale durch den Schaltzeitpunktdetektor 51 vom zweiten Mittel 113 abgeleitet. Dies geschieht, wie später beschrieben wird, sehr unterschiedlich und ist abhängig von den oben genannten Arten der durch die jeweils verwendeten Wandler bedingten lichtelektrischen Meß- und Abtastsysteme. Es werden in der Kanalsteuereinrichtung 50 Steuersignale für einen Schaltabschnittausgang A 5002, für einen Schaltabschnittausgang B 5003 und für einen Schaltabschnittausgang C 5004 erzeugt, wobei in diesen Fällen ein Impuls für die Dauer des Zustandes zur Verfügung steht. Weiter stehen noch an einem Schaltzeitpunktausgang 5001 kurze Impulse entsprechend den Schaltzeitpunkten 117, 118, 119 zur Verfügung.

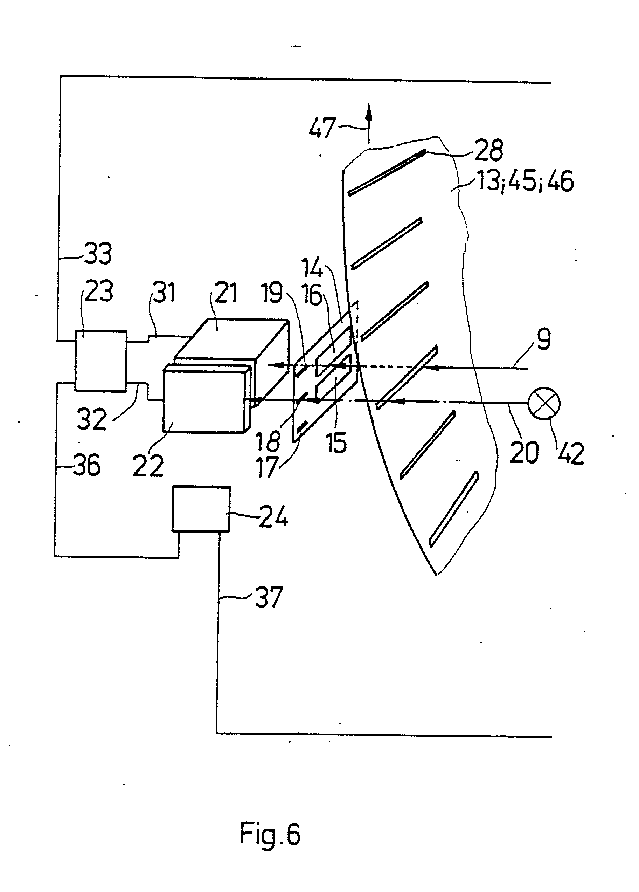

Damit eine Proportionalität zwischen dem vom Abtastelement 128 zurückgelegten Weg und dem Zeitpunkt für das entsprechende Bildsignal besteht, wird das Abtastelement synchron mit dem Taktgenerator 49 betrieben, dessen Signal auch zum Ausmessen der Strecken im Bild dient und der sequentiellen Bildsignalverarbeitungseinrichtung 60 und somit auch dem Rechenwerk 80 zugeführt wird. Das Abtastelement 128 ist bei Fernsehröhren der abtastende Elektronenstrahl, bei Festkörperempfängern das einzelne Empfängerelement und bei mechanischer Abtastung ein lichtdurchlässiger Schlitz 28 eines Schlitzträgers 13, wie in Fig. 6 dargestellt.

Wenn die Bildauswertung photometrisch erfolgen soll, eignen sich dafür nur Flächenmarken, wie in der Fig. 3a links dargestellt. Es ist zu erkennen, daß die lichtdurchlässigen Flächen im unabgeglichenen Zustand und deshalb die Lichtströme innerhalb der Schaltabschnitte A und B ungleich sind.

Im Rechenwerk 80 wird in Verbindung mit der sequentiellen Bildsignalverarbeitungseinrichtung 60 die Bildsignalfolge jeweils für die Schaltabschnitte A und B getrennt integriert oder bei Pulsmodulation gezählt oder bei binärkodierten Bildsignalen saldierend gespeichert. Dann werden die Ergebnisse nach jedem Schaltabschnitt A beispielsweise in die erste Funktionsgruppe 82 des Speichers 81 übertragen und gespeichert und ebenso nach jedem Schaltabschnitt B in der zweiten Funktionsgruppe 83 gespeichert.

Im Schaltabschnitt C, in dem kein Bildsignal vorliegt oder nicht signifikant ist, wird in der Arithmetikeinrichtung 90 die Berechnung der Regelabweichung normiert, also weitgehend unabhängig von der absoluten Lichtmenge durch Differenzbildung der entstandenen Ergebnisse mit den Werten A und B aus den Schaltabschnitt A und B mit anschließender Division durch das Gesamtergebnis aus beiden Schaltabschnitten gewonnen. Dieses Signal liegt am Schaltzeitpunktausgang 8005 an und bewirkt eine Verstellung des Stellgliedes 26, das die Halbleiterscheibe 1 mit den Justiermarken 4 und 5 bewegt (als Flächenmarken), bis der Lichtstrom in beiden Schaltabschnitten gleich ist. Schon aus Fig. 3a ist zu erkennen, daß durch die erfindungsgemäßen Anordnungen dieser Abgleich trotz weitgehender Dejustierung der Schablone ohne weiteres möglich ist. Das Arbeitsregime des Rechenwerkes 80 hängt weitgehend vom verwendeten Rechner ab.

Ebenso ist es davon abhängig, welche Funktionen der sequentiellen Bildverarbeitungseinrichtung 60 vom Rechner 80 übernommen werden. Deshalb sind beide Einheiten in der Fig. 2 als Block dargestellt.

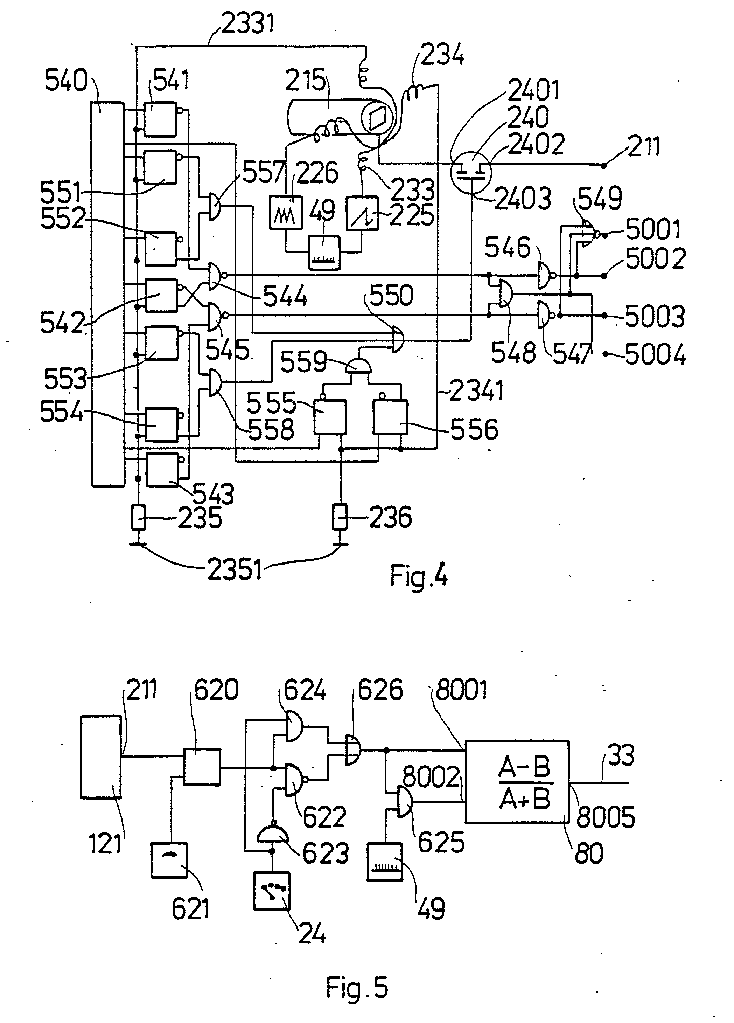

Vor der Wirkungsbeschreibung der Betriebsart für die Bildanalyse werden nachfolgend die Fig. 4 und 5 erläutert. In Fig. 4 ist das lichtelektrische Meß- und Abtastsystem unter Anwendung einer Fernsehkamera 215 dargestellt. Eine Spaltenablenkeinheit 233 ist verbunden einerseits mit einem Spaltensägezahngenerator 225 und andererseits über eine Leitung 2331 mit ersten Eingängen von Komparatoren 541 bis 543 und 551 bis 554 sowie einem Widerstand 235. Eine Zeilenablenkeinheit 234 ist verbunden einerseits mit einem Zeilensägezahngenerator 226 und andererseits über eine Leitung 2341 mit den ersten Eingägen von Komparatoren 555 und 556 und einem Widerstand 236. Die beiden Widerstände 235 und 236 sind mit ihren Enden 2351 mit Masse verbunden. Die beiden Sägezahngeneratoren 225 und 226 sind jeweils mit dem Taktgenerator 49 verbunden. Die anderen Eingänge der Komparatoren 541 bis 543 und 551 bis 556 sind mit einem Mehrfachvergleichswertsteller 540 verbunden. Der negierte Ausgang des Komparators 541 ist verbunden mit einem Eingang eines NAND-Gliedes 544 und der nicht negierte Ausgang des Komparators 542 steht mit dem anderen Eingang des NAND-Gliedes 544 in Verbindung. Der negierte Ausgang des Komparators 542 ist verbunden mit einem Eingang eines NAND-Gliedes 545 und der nicht negierte Ausgang des Komparators 543 mit einem anderen Eingang des NAND-Gliedes 545. Der Ausgang des NAND-Gliedes 544 ist sowohl mit dem Eingang eines NAND-Gliedes 546 als auch mit einem Eingang eines UND-Gliedes 548 verbunden. Der Ausgang des NAND-Gliedes 545 ist sowohl mit dem Eingang eines NAND-Gliedes 547 und einem anderen Eingang des UND-Gliedes 548 verbunden.

Der Ausgang des NAND-Gliedes 546 ist sowohl mit einem ersten Eingang eines ODER-Gliedes 549 als auch mit dem Schaltabschnittausgang A 5002 der Kanalsteuereinrichtung 50 verbunden. Der Ausgang des NAND-Gliedes 547 ist sowohl mit einem zweiten Eingang des ODER-Gliedes 549 als auch mit dem Schaltabschnittausgang B 5003 verbunden. Der Ausgang des UND-Gliedes 548 ist sowohl mit einem dritten Eingang des ODER-Gliedes 549 als auch mit dem Schaltabschnittausgang C 5004 verbunden. Der Ausgang des ODER-Gliedes 549 ist mit dem Schaltzeitpunktausgang 5001 verbunden.

Der negierte Ausgang des Komparators 551 ist verbunden mit einem Eingang eines UND-Gliedes 557 und der nicht negierte Ausgang des Komparators 552 mit einem anderen Eingang des UND-Gliedes 557. Der negierte Ausgang des Komparators 553 ist verbunden mit einem Eingang eines UND-Gliedes 558 und der nicht negierte Ausgang des Komparators 554 mit einem anderen Eingang des UND-Gliedes 558. Der negierte Ausgang des Komparators 555 ist verbunden mit einem Eingang eines UND-Gliedes 559. Von einem ODER-Glied 550 ist ein erster Eingang verbunden mit dem Ausgang des UND-Gliedes 557, ein zweiter Eingang mit dem Ausgang des UND-Gliedes 558, ein dritter Eingang mit dem Ausgang des UND-Gliedes 559 und der Ausgang mit dem Sperreingang 2403 einer Analogiesignaltorschaltung 240. Von der Analogiesignaltorschaltung 240 ist ein Signalkanaleingang 2401 verbunden mit dem Bildsignalausgang der Fernsehkamera 215 und ein Signalkanalausgang 2402 mit dem Ausgang 211 für analoge Bildsignale des lichtelektrischen Meß- und Abtastsystems 121.

Der Zweck der in Fig. 4 dargestellten Anordnung ist die Verwirklichung des ersten Mittels 114 und des zweiten Mittels 113 für den Fall, daß eine Fernsehkamera 215 als lichtelektrisches Meß- und Abtastsystem 121 dient. Hier ist speziell in der Fernsehkamera eine Kameraröhre enthalten, bei der die Abtastung des Bildes auf einer lichtempfindlichen Katode durch fokussierte Elektronen im Vakuum erfolgt.

Das erste Mittel 114 ist eine Analogsignaltorschaltung 240, hier dargestellt als Feldeffekttransistor, dessen Kanal in der Bildsignalleitung liegt, der das analoge Bildsignal entweder passieren läßt oder sperrt.

Die technischen Ausführungsmöglichkeiten einer solchen Analogsignaltorschaltung sind vielfältig und entsprechen den Lösungen für elektronische Zerhacker bei Chopperverstärkern.

Der Erzeugung des ersten 115 und zweiten 116 Bildausschnittes, die durch die ortsfeste Achse 38 getrennt sind, dienen binäre Torschaltungen in Verbindung mit Bereichskomparatoren, die noch zu erläutern sind. Solche Bereichskomparatoren arbeiten in Verbindung mit dem Mehrfachvergleichswertsteller 540. Dieser besitzt soviele Spannungsanschlüsse, wie Schaltzeitpunkte 117, 118, 119 und obere und untere, rechte und linke Bildbegrenzungen der Bildausschnitte 116 und 117 vorhanden sind. Die Verhältnisse der elektrischen Spannungen der Spannungsanschlüsse am Mehrfachvergleichswertsteller 540 entsprechen den geometrischen Verhältnissen der Schaltzeitpunkte 117, 118 und 119 sowie denen der Bildausschnitte 115 und 116 selbst und zueinander sowie einem notwendigen bildsignalfreien Bereich zwischen den Bildausschnitten 115 und 116.

Verglichen werden diese elektrischen Spannungen der Spannungsanschlüsse des Mehrfachvergleichwertstellers 540 mit einer laufenden elektrischen Spannung, die einer augenblicklichen Position des Abtastelementes 128, welches bei der Fernsehkamera 215 der augenblickliche Ort eines fokussierten Elektronenstrahles ist, entspricht. Bei Kameraröhren beispielsweise vom Vidikon-Typ, die vorteilhaft auch noch mit einem vorgeschalteten Bildverstärker in der Fernsehkamera 215 eingesetzt sein können, ist dann das Abtastelement 128 der auf eine lichtempfindliche Katode auftreffende abtastende Elektronenstrahl und bei ähnlich ausgestalteten (beispielsweise ebenfalls mit Bildverstärker) Kameraröhren vom Image-Dissector-Typ ist das abtastende Element 128 ein Diaphragma, durch das ein Teil eines auf das Diaphragma abgebildeten Elektronenbildes, welches dorthin von der lichtempfindlichen Katode abgebildet ist, in einen Photoelektronenvervielfacher gelangt.

Die augenblickliche Position des Abtastelementes 128 ist gegeben durch augenblickliche Ströme, die durch Spulen der Spaltenablenkeinheit 233 und der Zeilenablenkeinheit 234 fließen, die von einem Spaltensägezahngenerator 225 und einem Zeilensägezahngenerator 226 erzeugt werden.

Die laufende elektrische Spannung, die der augenblicklichen Position des Abtastelementes 128 entspricht, wird im Ausführungsbeispiel nach Fig. 4 über Widerstände 235 und 236 abgegriffen, die von den augenblicklichen Strömen von der Spaltenablenkeinheit 233 und Zeilenablenkeinheit 234 durchflossen werden.

Das ist die einfachste Lösung für eine stromabhängige Spannungserzeugung.

Andere zweckentsprechende Schaltungen zur Erzeugung stromabhängiger Größen sind beispielsweise durch stromspannungswandelnde Operationsverstärker möglich. Hierfür kann auch der Mehrfachvergleichswertsteller 540 statt der Spannungsabgriffe Stromgeneratoren enthalten.

Ein stromproportionaler Vergleich für die augenblickliche Position des Abtastelementes 128 wird vorgezogen, um Fehler für die Schaltzeitpunkte 117, 118 und 119, die ihrerseits Fehler für den Justiervorgang des ersten und des zweiten Gegenstandes 1 und 2 verursachen können, so klein wie möglich zu halten. Aus ähnlichen Gründen wird auch die magnetische Elektronenstrahlablenkung der Kameraröhre einer elektrostatischen Ablenkung vorgezogen.

Die oben angeführten Bereichskomparatoren sind aufgebaut mit Hilfe von jeweils zwei Komparatoren, beispielsweise 555 und 556, von denen jeweils ein negierter Ausgang des einen Komparators 555 mit einem nicht negierten Ausgang des jeweils anderen Komparators 556 UND-verknüpft ist, hier mit dem UND-Glied 559. Solche Komparatoren, die aus dem Vergleich zweier Analogspannungen zwischen ihren Eingängen ein binäres Ausgangssignal bilden, besitzen meist nicht, wie hier dargestellt, einen negierten und einen nicht negierten Ausgang.

Wenn nur ein einziger Ausgang benötigt wird, wird durch entsprechende Polung der Eingänge bewirkt, ob das binäre Ausgangssignal negiert oder nicht negiert vorliegt. Beide Ausgänge an einem Komparator können, wenn sie nicht vorhanden sind, durch Negation mittels eines zusätzlichen NAND-Gliedes verwirklicht werden.

Im einzelnen bilden die Komparatoren 551 und 552 in Verbindung mit dem UND-Glied 557 den Bereichskomparator für die Höhe das Bildausschnittes 115, wobei am Ausgang des UND-Gliedes 557 solange ein « high »-Zustand herrscht, wie die Höhe der Spannung an den gemeinsam verbundenen ersten Eingängen der Komparatoren 551 und 552 sich zwischen den Höhen der jeweiligen Spannungen an deren anderen Eingängen bewegt.

Weiterhin entspricht jeweils das Ausgangssignal des UND-Gliedes 558 der Höhe des Bildausschnittes 116, des UND-Gliedes 559 der Breite der Bildausschnitte 115 und 116, des NAND-Gliedes 544 dem Schaltabschnitt A und des NAND-Gliedes 545 dem Schaltabschnitt B.

Die Ausgangssignale dieser Bereichskomparatoren werden logisch weiter verarbeitet in folgender Weise : Für den bisher fehlenden Schaltabschnitt C wird das Signal für den Schaltabschnittausgang C 5004 mittels des UND-Gliedes 548 aus der logischen Aussage « nicht Schaltabschnitt A und nicht Schaltabschnitt B » gebildet.

Die Signale für den Schaltabschnittausgang A 5002 und den Schaltabschnittausgang B 5003 müssen wegen der vorstehenden logischen Aussage zunächst negiert vorliegen und die Signale nochmals negiert werden mittels der NAND-Glieder 546 und 547. Die kurzzeitigen Impulse für den Schaltzeitpunktausgang 5001 werden hier beispielsweise aus den Schaltlücken der Signale zwischen den Schaltabschnitten A, B und C mit Hilfe des ODER-Gliedes 549 gebildet. Die technische Realisierung kann je nach den vorliegenden Impulsverhältnissen auch durch Differentiation der Schaltabschnittsignale A, B und C geschehen.

Eingeschachtelt in die Schaltabschnitte A und B werden die Signale für die Bildausschnitte 115 und 116 durch ODER-Verknüpfung der Ausgangssignale der UND-Glieder 557 und 558 an den ersten beiden Eingängen des vereinfacht dargestellten ODER-Gliedes 550, dessen Ausgangssignal die Analogiesignaltorschaltung 240 innerhalb der Bildausschnitte 115 und 116 freigibt und außerhalb dieser sperrt. Falls die Bildbreite der Zeilenabtastung durch die Zeilenablenkeinheit 234 größer als die Breite der Bildausschnitte 116 und 117 ist, wird zusätzlich die Bildbreite durch das Ausgangssignal des UND-Gliedes 559 UND-verknüpft am dritten Eingang des ODER-Gliedes 550. Vorteilhaft realisiert könnten die Ausgänge der UND-Glieder 557 und 558 mit zwei Eingängen eines ODER-Gliedes und dessen Ausgang mit dem ersten Eingang eines weiteren UND-Gliedes und der Ausgang des UND-Gliedes 559 mit dem zweiten Eingang des weiteren UND-Gliedes verbunden sein, wie auch alle anderen logischen Verknüpfungen fachmännisch zweckmäßig anders ausgeführt sein können.

Am Ausgang des lichtelektrischen Meß- und Abtastsystems 211 liegt folglich das durch die Bildausschnitte 115 und 116 maskierte analoge Bildsignal von der Fernsehkamera 215 an, dessen Amplitude von der Bildhelligkeit am jeweiligen Ort des abtastenden Elektronenstrahls abhängt.

Dieser jeweilige Ort des Elektronenstrahles wird in bekannter Weise bestimmt durch den Strom, der durch die Spalten- und Zeilenablenkeinheiten 233 und 234 fließt und erzeugt wird in den Spalten- und Zeilensägezahngeneratoren 225 und 226, die ihrerseits synchronisiert gesteuert sind vom Taktgenerator 49.

Die Fig. 5 stellt die wichtigsten Mittel der sequentiellen Bildsignalverarbeitungseinrichtung 60 für die Betriebsart der Bildanalyse zur Strukturerkennung von zunächst beliebigen Justiermarken und zu deren Lagebestimmung dar.

Der Ausgang 211 für analoge Bildsignale des lichtelektrischen Meß- und Abtastsystems 121 ist verbunden mit einem ersten Eingang eines Bildsignalkomparators 610 und dessen zweiter Eingang mit einem Bildpegeleinsteller 621. Der Ausgang des Bildsignalkomparators 620 ist sowohl mit einen Eingang eines als Negator 622 dienenden NAND-Gliedes als auch mit einen Eingang eines als Tor 624 dienendes UND-Gliedes verbunden. Die Betriebsartenwahlreinrichtung 24 ist sowohl über ein als Umschalter 623 dienendes NAND-Glied mit einen zweiten Eingang des Negators 622 als auch direkt mit einem zweiten Eingang des Tores 624 verbunden. Der Ausgang des Tores 624 ist mit einem Eingang eines ODER-Gliedes 626 und der Ausgang des Negators 622 ist mit einem zweiten Eingang des ODER-Gliedes 626 verbunden. Der Ausgang des ODER-Gliedes 626 ist sowohl direkt mit einem ersten Rechenwerkseingang 8001 für das binäre Bildsignal des Rechenwerkes 80 als auch über einen Eingang eines als Taktkomparator 625 dienenden UND-Gliedes mit einem zweiten Rechenwerkseingang 8002 für den Bildsignaltakt verbunden. Der Taktgenerator 49 ist mit einem zweiten Eingang des Taktkomparators 625 verbunden.

Zur Erläuterung der zweifachen Wirkungsweise der in Fig. 5 dargestellten Anordnung in Verbindung mit den Fig. 1 bis 4 sei von den technologisch aufeinanderfolgenden Schritten bei der Herstellung von epitaktischen Halbleiterstrukturen ausgegangen, die bei der Fotolithografie und insbesondere bei der schrittweisen Projektionslithografie einerseits die Justierung der für eine einzige Halbleiterscheibe benötigten unterschiedlichen Schablonen 2 mit den nacheinander folgenden Strukturen und andererseits die Justierung des Halbleiterscheibe 1 zur Schablone 2 bedingen.

Im ersten Fall wird die Schablone 2, welche sowohl die jeweilige Struktur als auch die zugehörigen Justiermarken, hier als Schablonenfenster 7 und 8 ausgebildet, trägt, automatisch oder von Hand von einem Magazin so in den Strahlengang mit der optischen Achse 9 transportiert, daß sich, wie Fig. 3a zeigt, die Schablonenfenster 7 und 8 im Fangbereich des lichtelektrischen Meß- und Abtastsystems 121 befinden.

Die weitere automatische Nachjustierung soll vorteilhaft mit Hilfe der gleichen erfindungsgemäßen Anordnung erfolgen, mit der später auch die Justierung der Halbleiterscheibe 1 zur Schablone 2 zur Belichtung eines Fotoresists auf der Halbleiterscheibe 1 geschehen soll. Für den ersten Fall der Justierung der Schablone 2 bzw. ihrer Schablonenfenster 7 und 8 zu den Bildausschnitten 115 und 116 wird die Betriebsartenwahleinrichtung 24 automatisch oder von Hand in einen Schaltzustand gebracht, der erstens die Anordnung nach Fig. 5 wirksam macht, damit im Gegensatz zur oben beschriebenen photometrischen Bildauswertung der Justiervorgang mittels einer bildanalytischen Bildauswertung, also durch Erkennen und Lagebestimmung der Justiermarkenstruktur erfolgen kann. Zweitens sei für diesen ersten Fall der Justierung beispielsweise der Ausgang der Betriebsartenwahleinrichtung 24 in einem « low »-Zustand seines Signals. Dadurch wird mit Hilfe des als Umschalter 623 dienenden NAND-Gliedes das als Negator 622 dienende NAND-Glied freigegeben und das als Tor 624 dienende UND-Glied gesperrt.

Als lichtelektrische Meß- und Abtasteinrichtung 24 wird im Beispiel die Anordnung mit der Fernsehkamera 215 nach Fig. 4 gewählt. Der Bildpegeleinsteller 621 ist dazu so eingestellt, daß für die hellen Bildpartien, die in der Fig. 3a rechts der Bruchlinie und in den Figuren 3b und 3c dargestellt sind, das amplitudenmodulierte Bildsignal vom Ausgang 211 vom Bildkomparator 620 binär so verarbeitet wird, daß an dessen Ausgang beispielsweise ein « high »-Signal entsteht und ein « low »-Signal beim Vorliegen einer dunklen Bildpartie, wie sie bei einem der Bilder der Justiermarken 4' und 5' oder durch die Abschattung infolge der Schablonenfenster 7 und 8 vorliegt. Dieses Signal am Ausgang des Bildkomparators 620 ist ein binäres Bildsignal, welches in dem vorliegenden Schaltzustand der Betriebsartenwahleinrichtung 24 durch den Negator 622 negiert wird und über das ODER-Glied 626 an den ersten Rechenwerkseingang 8001 für das binäre Bildsignal gelangt. Für den « high »-Zustand des binären Bildsignals hinter dem ODER-Glied 626 wird dieses rechnerseitige binäre Bildsignal durch den Taktgenerator 49 mittels des als Taktkomparator 625 dienenden UND-Gliedes mit den Taktimpulsen des Taktgenerators 49 moduliert, so daß also für die Dauer des « high »-Zustandes des rechnerseitigen binären Bildsignals am zweiten Rechenwerkseingang 8002 für den Bildsignaltakt eine entsprechende Impulsfolge anliegt.

Die weitere Verarbeitung im Rechenwerk 80 erfolgt nach einer fachmännisch realisierbaren Software so, daß, bedingt durch die durch den Taktgenerator 49 und seinen Verbindungen verursachten Zuordnung eines Weges des Abtastelementes 128 zum zeitlichen Impulsabstand, zunächst eine Streckenbestimmung durch Zählen der Impulse für die Dauer des « high »-Zustände der rechnerseitigen binären Bildsignale, die am Eingang 8002 anliegen, vorgenommen wird.

Weiter wird durch Zählen der « high »-Zustände oder auch der « low »-Zustände des rechnerseitigen binären Bildsignals, die am ersten Rechenwerkseingang 8001 anliegen, in Zuordnung zu den Signalen für die Schaltabschnitte A, B und C die Position der Bildanteile zueinander und zu den erfindungsgemäßen getrennten Bildausschnitten 115 und 116 bewirkt.

Damit die zunächst angestrebte Justierung der Schablone 2 zum lichtelektrischen Meß- und Abtastsystem 121, hier im Beispiel zur Fernsehkamera 215 durchgeführt werden kann, werden in Weiterführung des erfinderischen Gedankens der getrennten Bildausschnitte 115 und 116 als ein weiteres erstes Mittel 114 dazu die Justiermarken der Schablone als schon erwähnte Schablonenfenster 7 und 8 so ausgebildet, daß nach den Fig. 3a bis 3c deren Bilder 7' und 8' in der Abtastebene 100 in Richtung der ortsfesten Achse 38 eine größere Ausdehnung als die Bildausschnitte 115 und 116 haben und damit Positionierungsfehler in dieser Richtung keinen Einfluß besitzen und daß die Bilder der Schablonenfenster 7' und 8' rechtwinklig zur ortsfesten Achse kleiner als die Ausdehnung der Bildausschnitte 115 und 116 sind.

Wenn der Abtastablauf des Elektronenstrahls der Kameraröhre der Fernsehkamera 215 dazu betrachtet wird, wobei nur die Spaltenrichtung als Abtastrichtung 47 als wesentlich gilt, da sich die Strukturen durch die Parallelität der ortsfesten Achse 38 mit der Schablonenfensterpaarachse 40 nur in dieser Richtung signifikant ändern, so ergibt sich folgender Wirkungsablauf : Zu Beginn einer periodischen Bildabtastung sei der Elektronenstrahl noch außerhalb des Schaltzeitpunktes 117 und im Schaltabschnitt C. Die Analogsignaltorschaltung 240 ist deshalb noch gesperrt, so daß am Bildsignalkomparator 620 praktisch ein Nullpotential, folglich an dessen Ausgang ein « low »-Signal und durch den Signalweg über den Negator 622 bedingt, am ersten Rechenwerkseingang 8001 ein « high »-Signal anliegt.

Dieses rechnerseitige binäre Bildsignal und auch der am zweiten Rechenwerkseingang 8002 anliegende Bildsignaltakt werden im Rechenwerk 80 noch nicht verarbeitet, da sich die Abtastung noch im Schaltabschnitt C befindet. Beim Erreichen des Schaltzeitpunktes 117 und damit des Schaltabschnittes A werden die am zweiten Rechenwerkseingang 8002 anliegenden Impulse des Bildsignaltaktes gezählt.

Nach dem Überschreiten des Schaltzeitpunktes 117 beginnt der Schaltabschnitt A und mit Beginn des Bildausschnittes 115 wird die Analogsignaltorschaltung 240 freigegeben. In der Abtastebene 100 folgt in der Fig. 3a in Abtastrichtung 47 (Fig. 2) weiterhin eine dunkle Bildpartie und deshalb liegt bei dem vorliegenden Schaltzustand der Betriebsartenwahleinrichtung 24 am ersten Eingang 8001 (Fig. 5) des Rechenwerkes 80 weiterhin ein « high »-Signal und am zweiten Rechenwerkseingang 8002 die Impulsfolge des Bildsignaltaktes an. Diese Impulsfolge wird zunächst in einen ersten Unterspeicher der ersten Funktionsgruppe 82 des Speichers 81 eingezählt bis zum Übergang zur ersten hellen Bildpartie. Dabei springt das binäre Bildsignal vom « low »- in den « high »-Zustand und das rechnerseitige binäre Bildsignal am ersten Rechenwerkseingang 8001 umgekehrt vom « high »- in den « low »-Zustand und die Impulsfolge des Bildsignaltaktes wird gesperrt für den zweiten Rechenwerkseingang 8002. Über eine hier nicht dargestellte Einrichtung kann das Taktsignal vom Taktgenerator 49 auch während des « low »-Zustandes am ersten Rechenwerkseingang 8001 zur Streckenbestimmung im Rechenwerk 80 weiter verarbeitet werden. Während der nächsten dunklen Bildpartie, hier das Bild der Justiermarke 5' von der Halbleiterscheibe 1, kann die Impulsfolge des Bildsignaltaktes in einen zweiten Unterspeicher der ersten Funktionsgruppe 82 des Speichers 81 eingezählt werden und nach Fig. 3a rechts der Bruchlinie bei einer Kantenmarke für die übernächste dunkle Bildpartie in einen dritten Unterspeicher der ersten Funktionsgruppe 82 und bei Mehrfachkantenmarken auch noch in vierte, usw. Unterspeicher dieser Funktionsgruppe 82 bis der obere Rand des Bildausschnittes 116 und dann der Schaltzeitpunkt 118 und damit das Ende des Schaltabschnittes A erreicht ist.

Für den Schaltabschnitt B, der mit dem Schaltzeitpunkt 118 beginnt, erfolgt das Abspeichern der Impulsfolgen des Bildsignaltaktes in ähnlicher Weise wie für den Schaltabschnitt A mit dem Unterschied, daß ein erster, zweiter, usw. Unterspeicher der zweiten Funktionsgruppe 83 des Speichers 81 belegt wird.

Im Schaltabschnitt C, der mit dem Überschreiten des Schaltzeitpunktes 119 beginnt, wird mittels der Arithmetikeinrichtung 90 sowohl ein Wert A, der dem Inhalt des ersten Unterspeichers der ersten Funktionsgruppe 82 entspricht, als auch ein Wert B, der dem Inhalt des zuletzt gefüllten Unterspeichers der Funktionsgruppe 83 zu einem Wert A — B/A + B als Steuersignal für die Regelabweichung gebildet.

Dieses Steuersignal für die Regelabweichung liegt am Ausgang 8005 des Rechenwerkes 80 und weiter über die Signalleitung 33 an der Antriebsartenweiche 25 an. Diese Antriebsartenweiche 25 ist für den vorstehend behandelten Betriebsartfall von der Betriebsartenwahleinrichtung 24 über die Signalleitung 37 so gesteuert, daß die Signalleitung 33 mit der Signalleitung 35 verbunden ist, so daß das Steuersignal für die Regelabweichung letztlich am zweiten Stellglied 27 anliegt und dadurch die Schablone 2 soweit verstellt wird, bis nach möglichst wenig Abtastzyklen, im Grenzfall nur einem Abtastzyklus der Fernsehkamera 215, die Werte A und B ausreichend gleich sind. Anders betrachtet erfolgt der Abgleich bis zur Gleichheit der Abstände von den äußeren Schaltpunkten 117 bzw. 119 bis zu den jeweils äußeren Schablonenfensterrändern von 7' bzw. 8' bzw. dem Bildausschnittrand von 115 oder 116.

In der Fig. 3b ist der abgeglichene Zustand mit einem zulässigen Restfehler, einer Differenz zwischen der ortsfesten Achse 38 und der Abbildung der Schablonenfensterpaarachse 40' dargestellt.

Es ist zu erkennen, daß so auf einfache Art sowohl bei Anwesenheit von Flächen- als auch von Kantenmarken im abzutastenden Bild durch die vorteilhafte Ausgestaltung der Schablonenfenster 7 und 8 als Schablonenfensterpaar mit den oben genannten geometrischen Bedingungen und durch einfache Umschaltung in der sequentiellen Bildsignalverarbeitungseinrichtung 60 und des Rechenwerkes 80 die Justierung der Schablone 2 ermöglicht wird.

Zu bemerken ist, daß im Prinzip auch der Abgleich der Schablone 2 vom mittleren Schaltpunkt 118 bis zu den inneren Schablonenfensterrändern von 7' und 8' möglich ist, aber mit Rücksicht auf ein stabiles Regelverhalten bei Flächenmarken ist es vorteilhaft, wenn diese innenliegend, wie in Fig. 3a links dargestellt, angeordnet sind. Dann stehen nur, wie beschrieben, die Abstände von den äußeren Schaltpunkten 117, 119 zur Verfügung.

Der nächste Justiervorgang im technologischen Ablauf bei der hier bevorzugt betrachteten schrittweisen Projektionslithografie soll der Abgleich der Halbleiterscheibe 1 zur Schablone 2 mittels der Justiermarken 4, 5 sowie der Schablonenfenster 7 und 8 sein, wobei die Justiermarken 4, 5 als Kantenmarken ausgebildet sein sollen. Die Fig. 3b stellt den Anfangszustand für diesen Justiervorgang dar. Hierbei ist die Schablone 2 mit dem beschriebenen Restfehler hinreichend genau justiert, während die Halbleiterscheibe 1 in die Lage, wie sie an Hand der Bilder der Justiermarken 4' und 5' zu sehen ist, gesteuert transportiert wurde.

Die Betriebsartenwahleinrichtung 24 (Fig. 2, 5) ist eingestellt auf Bildanalyse, also Strukturerkennung und Lagebestimmung und auf Justierung der Halbleiterscheibe 1 zur Schablone 2.

Hierbei ist zunächst die Antriebsartenweiche 25 (Fig. 1) so gesteuert, daß die Signalleitung 33 und 34 verbunden sind und die Schaltung nach Fig. 5 ist aktiviert. In der Fig. 5 liegt dabei am Eingang des Umschalters 623 ein « high »-Signal an, wodurch der Negator 622 gesperrt und das Tor 624 geöffnet ist. Das rechnerseitige binäre Bildsignal am ersten Eingang 8001 des Rechenwerkes 80 ist in dieser Betriebsart praktisch identisch mit dem binären Bildsignal am Ausgang des Bildsignalkomparators 620. Demzufolge liegt am zweiten Rechenwerkseingang 8002 dann eine Impulsfolge des Bildsignaltaktes an, während das Abtastelement 128, hier der Elektronenstrahl der Fernsehkamera 215, eine helle Bildpartie abtastet. So wird bei der periodischen Abtastung zunächst im Schaltabschnitt C bis zum äußeren Rand des Bildausschnittes 115 die Analogiesignaltorschaltung 240 gesperrt. Nach dem Überschreiten des äußeren Randes des Bildausschnittes 115 bleibt das binäre Bildsignal noch im « low »-Zustand, da eine dunkle Bildpartie infolge des lichtundurchlässigen Randes der Bilder der Schablonenfenster 7' und 8' vorliegt. Eine helle Bildpartie folgt vom äußeren Rand des Bildes des Schablonenfensters 7' bis zum äußeren Rand des Bildes der Justiermarke 5' als Kantenmarke. Es liegt so der « high »-Zustand des binären Bildsignals am ersten Rechenwerkseingang 8001 und eine Impulsfolge am zweiten Rechenwerkseingang 8002 an und im Rechenwerk 80 wird diese Impulsfolge in den ersten Unterspeicher der ersten Funktionsgruppe 82 (bedingt durch das Steuersignal für den Schaltabschnitt A vom Schaltabschnittsausgang 5002 der Kanalsteuereinrichtung 50) eingezählt und gespeichert. Die nächste Impulsfolge des Bildsignaltaktes, die sich während der Abtastung der hellen Bildpartie zwischen dem inneren Rand des Bildes der Justiermarke 5' und dem inneren Rand des Bildes des Schablonenfensters 7' ergibt, wird beispielsweise in dem zweiten Unterspeicher der ersten Funktionsgruppe 82 gespeichert.

Es folgt dann wieder eine dunkle Bildpartie, verursacht durch das innere lichtundurchlässige Gebiet zwischen den Bildern der Schablonenfenster 7' und 8'. Innerhalb des Steges zwischen den beiden Bildausschnitten 115 und 116 ist wieder die Analogsignaltorschaltung 240 auf Grund der schon beschriebenen logischen Verknüpfungen für jegliches Bildsignal gesperrt. Es folgt im Schaltabschnitt B erst eine weitere dunkle Bildpartie, bis der innere Rand des Bildes des Schablonenfensters 8' erreicht wird. Die nächste Impulsfolge des Bildsignaltaktes wird beispielsweise in den ersten Unterspeicher der durch das Signal für den Schaltabschnitt B vom Schaltabschnittausgang 5003 der Kanalsteuereinrichtung 50 aktivierten zweiten Funktionsgruppe 83 während der Abtastzeit zwischen dem inneren Rand des Bildes des Schablonenfensters 8' und dem inneren Rand des Bildes der Justiermarke 4' eingespeichert.

Die folgende Impulsfolge zwischen dem äußeren Rand des Bildes der Justiermarke 4' und dem äußeren Rand des Bildes des Schablonenfensters 8' gelangt dann beispielsweise in den zweiten Unterspeicher der zweiten Funktionsgruppe 83.

Die Arithmetikeinrichtung 90 oder wenn nötig noch weitere bilden nach fachmännischer Wahl entweder aus dem zuerst gespeicherten Wert A aus der ersten Funktionsgruppe 82 und dem zuletzt gespeicherten Wert B aus der zweiten Funktionsgruppe 83 den Wert für die Regelabweichung zu A — B /A + B oder aber aus dem zuletzt gespeicherten Wert A aus der ersten Funktionsgruppe 82 und dem zuletzt gespeicherten Wert B aus der zweiten Funktionsgruppe 83 wie vorstehend den Wert der Regelabweichung oder besonders vorteilhaft zum Ausgleich von Fehlern den Mittelwert dieser beiden vorstehend beschriebenen Werte für den Sollwert zum Steuersignal für das erste Stellglied 26 zum Verstellen der Lage der Halbleiterscheibe bis die Werte A und B gleich sind, wie es in der Fig. 3c dargestellt ist.

Es ist deutlich zu sehen, daß durch die erfindungsgemäßen Mittel eine exakte Justierung der Halbleiterscheibe 1 zur Schablone 2 durchgeführt wird, obwohl die Schablone nur annähernd genau zur ortsfesten Achse 38 des lichtelektrischen Meß- und Abtastsystems 121 justiert wurde.

Diese eben beschriebene Justierung verläuft sinngemäß auch bei Flächenmarken und auch mehrfachen Kantenmarken, wie leicht nachzuvollziehen ist.

Bei der bevorzugt betrachteten schrittweisen Projektionslithographie beeinflußt in entscheidender Weise die Geschwindigkeit der vorstehend beschriebenen Justiervorgänge die Arbeitsproduktivität der dafür benötigten Geräte. Diese Justiergeschwindigkeit bedingt Regelkreise mit hoher Eigenresonanz und damit verbunden hohe Abtastfrequenzen für das Abtastelement 128. Bei gegebenen und oft ungünstigen monochromatischen Lichtverhältnissen für das lichtelektrische Meß- und Abtastsystem 121, unter Umständen verbunden mit schlechtem Kontrast der Justiermarken 4 und 5 gegenüber ihrer unmittelbarer Umgebung und der hohen Relativgeschwindigkeit der Justiermarken 4 und 5 in bezug auf die Abtastfrequenz für das Abtastelement 128 läßt verschiedene Arten von lichtelektrischen Meß- und Abtastsystemen 121, wie sie oben schon erwähnt wurden, mit jeweils unterschiedlichen Vor- und Nachteilen miteinander konkurrieren.

Die soeben betrachtete Fernsehkamera 215 im Ausführungsbeispiel besitzt mit einer Kameraröhre vom Vidicontyp einerseits den Vorteil eines relativ guten Signal-Rauschverhältnisses in bezug auf das elementare Photonenrauschen wegen der speichernden Wirkung der Fotokatode und andererseits den Nachteil einer Verschlechterung des Kontrastes bei schnell bewegten Bildern, die, wie beschrieben, hier vorliegen können.

Deshalb soll als Ausführungsbeispiel noch die mechanische Abtastung mittels eines Schlitzträgers 13 mit jeweils optisch wirksamen Schlitzen 28 an Hand der Fig. 6 erläutert werden, bei welcher ein noch zu erläuternder lichtelektrischer Wandler 21 nachteilig unmittelbar vom Signal-Rauschverhältnis des Photonenrauschens abhängig ist und dieses nicht verbessern kann, da nur Augenblickswerte des Lichtes zu dem Bildsignal verarbeitbar sind. Von Vorteil ist jedoch, daß, wie auch bei einem Imagedissektor als Kameraröhre bei dem oben beschriebenen Ausführungsbeispiel, bei schnell bewegten Bildern kein Kontrastverlust auftritt.

Es obliegt demzufolge dem fachmännischen Ermessen, welche Art des lichtelektrischen Meß- und Abtastsystems 121 unter gegebenen Bedingungen der Vorzug gegeben wird. Die Fig. 6 ist ebenso wie Fig. 2 mit Fig. 1 zu komplettieren und zeigt die vorstehend angeführte weitere Möglichkeit der Bildabtastung mit mechanischen Mitteln. Ein Schlitzträger 13, der von einem nicht dargestellten Antriebsmotor 45 mit der ebenfalls nicht dargestellten Ansteuereinrichtung 46 in der Laufrichtung 47 angetrieben wird, trägt Schlitze 28, die im Abbildungsstrahlengang mit der optischen Achse 9 angeordnet sind. Weiterhin befinden sich im Abbildungsstrahlengang eine Maske 14 mit einem ersten Bildausbruch 15 und einem zweiten Bildausbruch 16 und ein lichtelektrischer Wandler 21. Längs einer zweiten optischen Achse 20, die durch die äußeren Bereiche der Schlitze 28 verläuft, sind eine Lichtquelle 42, drei sich in der Maske 14 befindliche schlitzartige Durchbrüche 17, 18, 19 und mindestens ein lichtelektrischer Empfänger 22 angeordnet. Eine Signalverarbeitungseinrichtung 23 ist über Signalleitungen 31, 32 mit den lichtelektrischen Wandler 21 und Empfänger 22 verbunden und bildet mit diesen zusammen eine vereinfachte und zusammenfassende Darstellung für die Elemente der Fig. 2. Die Signalverarbeitungseinrichtung 23 ist durch eine Signalleitung 36 mit der Betriebsartenwahleinrichtung 24 verbunden. Über die Signalleitungen 33 und 37 erfolgt der Anschluß an die in Fig. 1 dargestellte Antriebsartenweiche 25.

Die Wirkungsweise ist weitgehend analog der Wirkungsweise mit der Fernsehkamera 215. Der lichtelektrische Wandler 21 ist vorzugsweise ein Fotoelektronenvervielfacher, der im Photonenzählbetrieb in Verbindung mit einem zweckentsprechenden Diskriminatorverstärker betrieben wird, damit als unvermeidliche Rauschquelle praktisch nur das Licht vom Strahlengang 9 störenden Einfluß haben darf. Die lichtundurchlässige Maske 14 mit seinem ersten und zweiten Bildausbruch 15 und 16 dient als Mittel zur Verwirklichung des ersten und zweiten Bildausschnittes 115 und 116. Diese sind innerhalb der Fertigungstoleranzen gleich ausgebildet. Sie sind zur ortsfesten Achse 38 und auch zur optischen Achse 9 einander gegenüberliegend angeordnet, vorteilhaft mit einem lichtundurchlässigen Mittelsteg, um für die beabsichtigte Verwirklichung eines Zweistrahlverfahrens eine möglichst toleranzenabhängige saubere Trennung der Bildsignale für die Bildausschnitte 115 und 116 zu gewährleisten. Zur Vermeidung von Kontrastverlusten bei der Bildabtastung durch einen der Schlitze 28 wird dieser sowie die ortsfeste Achse 38 für die Bildausbrüche 15 und 16 möglichst genau parallel zur Symmetrieachse 39 und auch 40 der Justiermarken 4, 5 und 7, 8 ausgerichtet.

Bei der allgemeinen gleichförmigen Bewegung des Schlitzträgers 13 fällt je nach augenblicklicher Stellung des jeweils dicht an der Maske 14 vorbeilaufenden Schlitzes 28 entsprechend den Fig. 3a bis 3c unterschiedlich viel Licht auf den lichtelektrischen Wandler 21, wobei mit wachsender Schlitzbreite sich einerseits das Signal-Rauschverhältnis für das Bildsignal verbessert, aber sich andererseits die Auflösbarkeit des Bildes und der Kontrast verschlechtert.

Das Bildsignal selbst ist bei der vorteilhaften Photonenzählmethode eine mehr oder weniger dichte Folge von Impulsen. Zur Gewinnung des Bildsignals in der Signalverarbeitungseinrichtung 23 dient eine hier nicht weiter dargestellte Einrichtung, die gesteuert vom Taktgenerator 49 in fester Zeit- bzw. Wegintervallen, welche der gewünschten Auflösung für die Bildanalyse in bezug auf die Strukturerkennbarkeit einerseits und die Lagebestimmung andererseits entsprechen soll, die Impulse gezählt, die von den Photoelektronen des lichtelektrischen Wandlers 21 ausgehen. Diese Photoelektronenimpulse je Zeitintervall entsprechen demzufolge der örtlichen Helligkeit des abgetasteten Bildes. Nach jedem Zeitintervall wird die Anzahl der Photoelektronenimpulse verglichen mit einer vorgewählten Zahl, die einen Schwellwert der Helligkeit bzw. dem dieser Helligkeit entsprechenden Lichtstrom entspricht. Dieser Vergleich bewirkt ein auf das Zeit- bzw. Wegintervall bezogenes binäres Bildsignal, welches als getaktetes Bildbinärsignal bezeichnet werden soll. Vorteilhaft wird auch ein negiertes getaktetes Bildbinärsignal gebildet, welches Impulse für den Zustand liefert, wenn der Schwellwert der Helligkeit unterschritten ist, während das getaktete Bildbinärsignal Impulse liefert, wenn der Schwellwert der Helligkeit überschritten ist. Über ein Auffang-Flip-Flop wird der Zustand entweder des getakteten oder des negiert getakteten Bildbinärsignals festgehalten, bis sich jeweils der Zustand ändert. Es entsteht so am Ausgang des Auffang-Flip-Flops ein Signal, welches dem binären Bildsignal am Ausgang des Bildsignalkomparators 620 entspricht, so daß die Anordnung nach Fig. 5 zweckentsprechend wie angegeben fachmännisch abzuändern ist. Zur Anpassung an das Signal-Rauschverhältnis kann die Abtastgeschwindigkeit des Schlitzträgers 13 variiert werden. Dadurch, daß bei den beschriebenen Anordnungen vorteilhaft nach jedem Abtastzyklus, dem Vorbeilaufen eines Schlitzes 28 an den beiden Bildausbrüchen 15 und 16, ein normierten Wert für die Regelabweichung ermittelt wird, ist diese Anordnung mit dem beweglichen Schlitzträger 13 weitgehend unabhängig von den Toleranzen der einzelnen Schlitze 28.

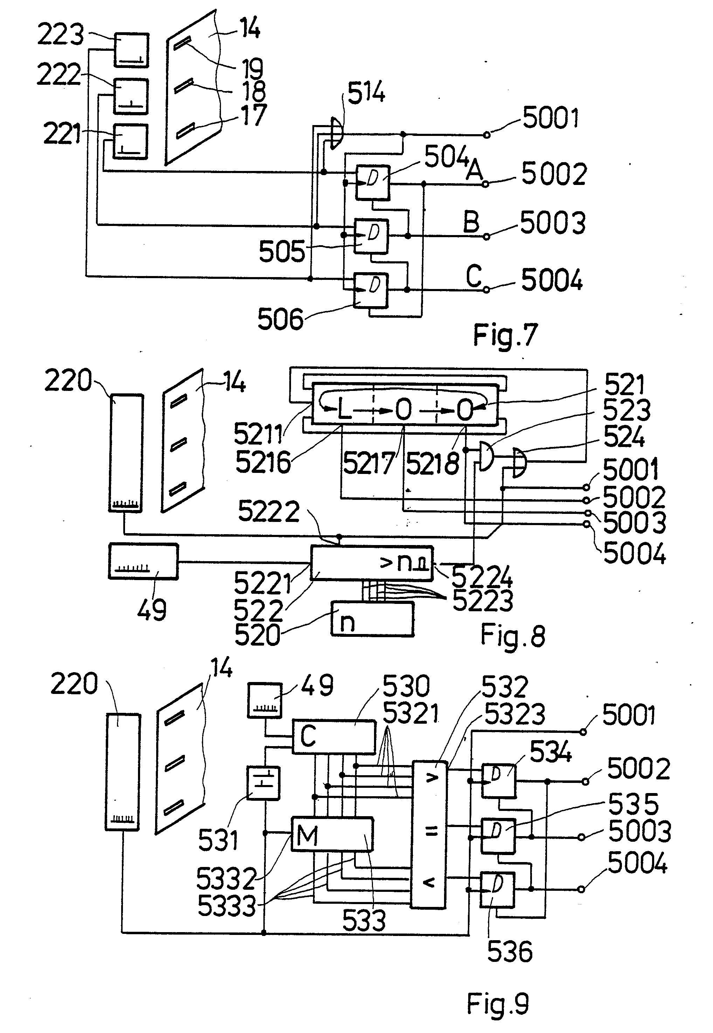

In den Fig. 7, 8 und 9 sind für die zuletzt beschriebene Anordnung mit der mechanischen Abtastung durch Schlitzträger 13 verschiedene Anordnungen von Schaltzeitpunktdetektoren 51 entsprechend Fig. 2 zur Steuersignalgewinnung für die Kanasteuereinrichtung 50 dargestellt. Diese Anordnungen und die in Fig. 4 enthaltene Anordnung für die Kanalsteuereinrichtung stellen die möglichen Prinziplösungen dar, die auch für hier nicht speziell behandelte Varianten von lichtelektrischen Meß- und Abtastsystemen 121, wie solche mit Festkörperempfängern, beispielsweise CCD-Zeilen, Anwendung finden können. Fehler in der Steuersignalgewinnung für die Kanalsteuereinrichtung gehen bei der erfindungsgemäßen Lösung nur sehr wenig ein, da die Schaltzeitpunkte 117, 118 und 119 außerhalb der Bildausschnitte 115 und 116 liegen, jedoch ist bei der photometrischen Bildauswertung ein Restfehler durch Streulicht und andere Randerscheinungen möglich. Deshalb ist auch eine weitgehend exakte Zuordnung der Steuersignale für die Schaltzeitpunkte 117, 118 und 119 in bezug auf die Bildausschnitte 115 und 116 anzustreben.

Diese exakte Zuordnung ist bei der Fig. 4 durch die beschriebene Verknüpfung der Ablenkströme für die Fernsehkamera 215 mit den gemeinsam verbundenen Komparatoreingängen sowohl für die Schaltzeitpunkte 117, 118 und 119 als auch für die Bildausschnitte 115 und 116 durchgeführt. Für die mechanische Bildabtastung nach Fig. 5 wird die exakte Zuordnung vorteilhaft dadurch erreicht, daß die Maske 14 sowohl mit dem ersten und zweiten Bildausbruch 15 und 16 als auch mit einem ersten, zweiten und dritten Durchbruch 16, 17 und 18 versehen ist, die nach Herstellung dieser Maske 14 praktisch unveränderbar zueinander sind. Der lichtelektrische Empfänger 22 kann in der praktischen Ausführung nach dem Beispiel in Fig. 7 aus einem ersten, zweiten und dritten lichtelektrischen Empfänger 221, 222 und 223 bestehen, wobei diese jeweils dem ersten, zweiten und dritten Durchbruch 16, 17 und 18 zugeordnet sind und in Verbindung mit dem Schlitz 28 und einer Lichtquelle 42 jeweils eine Lichtschranke mit einer optischen Achse 20 bilden. Die gegebenenfalls notwendigen optischen Abbildungssysteme sind dabei für das Prinzip unwesentlich und deshalb nicht dargestellt. In den Beispielen nach Fig. 8 und 9 sind dagegen für alle drei Durchbrüche 17, 18 und 19 nur jeweils ein gemeinsamer lichtelektrischer Empfänger 220 vorgesehen, wobei die Anordnung nach Fig. 7 zwar die einfachste elektronische Verarbeitung besitzt, jedoch dann auf Schwierigkeiten bei der Realisierung stößt, wenn die Abstände zwischen den drei Durchbrüchen 17, 18 und 19 so eng sind, daß die Anordnung von drei lichtelektrischen Empfängern 221, 222 und 223 auf Schwierigkeiten stößt oder unmöglich ist. Außerdem ist der reale Schaltzeitpunkt 117, 118 und 119 nicht identisch mit der räumlichen Anordnung der lichtelektrischen Emfänger 221, 222 und 223 wegen unterschiedlicher optoelektrischer Eigenschaften, wie der Empfindlichkeit, z. B. « Schielen » der optischen räumlichen Empfindlichkeitsverteilung, weshalb die Anordnung mit nur einem gemeinsamen lichtelektrischen Empfänger 220 vorteilhaft sein kann. Bei dem Beispiel nach Fig. 7 sind der erste, zweite und dritte lichtelektrische Empfänger 221, 222 und 223, die in der Lage sein müssen, ein logisch verarbeitbares Ausgangssignal abzugeben, indem sie, wenn nötig, einen Pegelanpaßverstärker besitzen, der nicht gesondert dargestellt ist, ausgangsseitig verbunden mit jeweils einem der Eingänge eines ODER-Gliedes 514, dessen Ausgang verbunden ist sowohl mit dem Schaltzeitpunktausgang 5001 als auch mit den untereinander verbundenen Übernahmeeingängen eines ersten, zweiten und dritten Impulsspeichers 504, 505 und 506.

Diese Impulsspeicher können übliche D-Flip-Flops sein, wobei der Übernahmeeingang der « Takt »- oder « Clock »-Eingang ist.

Der Ausgang des ersten lichtelektrischen Empfängers 221 ist außerdem verbunden mit dem Dateneingang des ersten Impulsspeichers 504 (bei D-Flip-Flops ist das der D-Eingang), ebenso der zweite lichtelektrische Empfänger 222 mit dem Dateneingang des zweiten Impulsspeichers 505 und außerdem der dritte lichtelektrische Empfänger 223 mit dem Dateneingang des dritten Impulsspeichers 506. Der Ausgang des ersten Impulsspeichers 504 ist sowohl mit dem Schaltabschnittausgang A 5002 als auch mit dem Löscheingang des dritten Impulsspeichers 506 verbunden und in ähnlicher Weise der Ausgang des zweiten Impulsspeichers 505 mit dem Schaltabschnittausgang B 5003 und dem Löscheingang des ersten Impulsspeichers 504 sowie der Ausgang des dritten Impulsspeichers 506 mit dem Schaltabschnittausgang C 5004 und dem Löscheingang des zweiten Impulsspeichers 505.

Die Wirkung beruht darauf, daß die Impulsspeicher 504, 505 und 506 als selbsteinfädelnder und parallel angesteuerter Ringzähler aufgebaut ist, in dem eine logische « 1 » umläuft, beispielsweise hat immer derjenige Ausgang eines der Impulsspeicher 504, 505 und 506 einen « high »-Zustand, der druch einen Impuls eines der drei lichtelektrischen Empfänger 221, 222 und 223 über den D-Eingang jeweils vorbereitet und durch den Impuls vom Ausgang des ODER-Gliedes 514 gesetzt wird. Am Schaltzeitpunktausgang 5001 erscheint so bei jedem Passieren eines der Durchbrüche 17, 18 und 19 durch den Schlitz 28 ein Impuls und am Schaltabschnittausgang A 5002 besitzt das Signal einen « high »-Zustand, während der Schlitz 28 sich zwischen dem ersten und zweiten Durchbruch 17 und 18, also zwischen dem ersten Schaltzeitpunkt 117 und dem zweiten Schaltzeitpunkt 118 befindet und so den Schaltabschnitt A signalisiert. Entsprechend besitzt das Signal am Schaltabschnittausgang B 5003 einen « high »-Zustand zwischen dem zweiten und dritten Durchbruch 18 und 19 und signalisiert so den Schaltabschnitt B zwischen dem zweiten und dritten Schaltzeitpunkt 118 und 119 und in gleicher Weise wird der Schaltabschnitt C am Schaltabschnittausgang C 5004 zwischen dem dritten und ersten Schaltzeitpunkt 119 und 117 signalisiert. Die in Fig. 7 dargestellte Anordnung kann selbstverständlich entsprechend den zur Zeit günstigsten Bauelementen ausgestattet werden.

Die vorteilhafte Ausrüstung der Lichtschranken mit nur einem lichtelektrischen Empfänger 220 in den Beispielen nach Fig. 8 und 9 gelingt dann, wen bei der Bewegung des Schlitzes 28 in der Laufrichtung 47 die Schaltabschnitte A und B zwischen den Durchbrüchen 17 und 18 sowie 18 und 19 praktisch gleich, aber der Schaltabschnitt C zwischen dem dritten und dem ersten Durchbruch 19 und 17 deutlich ungleich zu den Schaltabschnitten A und B ist. Da nur die Schaltabschnitte A und B für den Meßvorgang wesentlich sind, ist es anzustreben, deren Anteil an einem Abtastzyklus möglichst groß zu halten, daher ist die oben beschriebene Auswertung der Meßergebnisse während des Schaltabschnittes C in möglichst kurzer Zeit durchzuführen, um damit das Signal-Rauschverhältnis möglichst günstig zu gestalten. Es ist so vorteilhaft und Voraussetzung für die Schaltzeitpunktdetektoren 51 entsprechend Fig. 1 nach Fig. 8 und 9, daß der Abstand der drei schlitzförmigen Durchbrüche 17, 18 und 19 voneinander größer als ein Drittel und kleiner als die Hälfte des Abstandes zweier benachbarter Schlitze 28 des beweglichen Schlitzträgers 13 ist, wobei dieser Schlitzträger 13 eine Scheibe, wie in Fig. 6 dargestellt, oder ein unendliches Band oder auch eine schwingende Blende sein kann.

Die Anordnung nach Der Fig. 8 ermöglicht unter den vorstehenden Bedingungen und mit Hilfe dieser Bedingungen, mit nur einem lichtelektrischen Empfänger 220 die Schaltzeitpunkte 117, 118 und 119 zu den schlitzförmigen Durchbrüchen 17, 18 und 19 richtig zuzuordnen.

Der Taktgenerator 49, dessen Taktfrequenz mit der Geschwindigkeit des Schlitzes 28 durch nicht näher dargestellte Mittel und Verbindungen synchronisiert ist, ist auch mit dem Zähleingang 5221 eines setzbaren Zählers 522 verbunden. Ein Sollwertsteller 520 für eine feste oder wählbare binärkodierte Impulszahl ist mit mindestens soviel Leitungen, wie es die Bits für die binärkodierte Impulszahl erfordern, mit den Setzeingängen 5223 des setzbaren Zählers 522 verbunden. Im Beispiel sind vier Signalleitungen für beispielsweise eine Zahlentetrade eingezeichnet. Der lichtelektrische Empfänger 220 ist sowohl mit dem Setzbefehlseingang 5222 des setzbaren Zählers 522 als auch über einen Eingang eines ODER-Gliedes 524 mit dem Takteingang 5211 eines dreistufigen Ringzählers 521 und außerdem mit dem Schaltzeitpunktausgang 5001 verbunden, wobei auch der Übertragsimpulsausgang 5224 des setzbaren Zählers 522 über einen Eingang des UND-Gliedes 523 sowie über die Ausgangsverbindung dieses UND-Gliedes 523 mit einem zweiten Eingang des ODER-Gliedes 524 ebenfalls mit dem Takteingang 5211 des dreistufigen Ringzählers 521 in Verbindung steht. Der Ringzähler 521 ist mit den üblichen beiden unbezeichneten Rückführverbindungen dargestellt und sein Ausgang der ersten Stufe 5216 ist mit dem Schaltabschnittausgang A 5002, sein Ausgang der zweiten Stufe 5217 ist mit dem Schaltabschnittausgang B 5003 und sein Ausgang der dritten Stufe 5218 ist sowohl mit dem anderen Eingang des UND-Gliedes 523 als auch mit dem Schaltabschnittausgang C 5004 verbunden.

Die zunächst nicht den Durchbrüchen 17, 18 und 19 der Maske 14 (wie in Fig. 7) zugeordneten Impulse vom lichtelektrischen Empfänger 220 gelangen einmal direkt zum Schaltzeitpunktausgang 5001 und zum anderen zum Takteingang des Ringzählers 521, durch dessen drei Stufen eine logische « 1 » in der dargestellten Schleife bei jedem Impuls vom lichtelektrischen Empfänger 220 um eine Stufe nach rechts im Kreis weiter geschoben wird, wobei diese logische « 1 » zunächst beliebig zu den Schaltzeitpunkten 117, 118 und 119 liegen kann.

Außerdem gelangen die Impulse vom lichtelektrischen Empfänger 220 zum Setzbefehlseingang 5222 und setzen den Zähler 522 mit der binärkodierten Impulszahl n, die vom Sollwertsteller 520 an den Setzeingängen 5223 anliegen. Diese Impulszahl n muß so gewählt sein, daß sie größer ist als die Anzahl der Impulse vom Taktgenerator 49, die dem Schaltabschnitt C zwischen dem dritten und dem ersten Schaltzeitpunkt 119 und 117 entsprechen und kleiner als die Anzahl der Impulse ist, die dem Schaltabschnitt A oder B zwischen den Schaltzeitpunkten 117 und 118 oder 118 und 119 zugeordnet sind. Der setzbare Zähler 522 ist üblicherweise ein Rückwärtszähler, der dann einen Impuls an seinem Übertragsimpulsausgang 5224 abgibt, wenn die Anzahl der Impulse vom Taktgenerator 49 gleich der gesetzten Impulszahl n oder größer ist, aber keinen Impuls abgibt, wenn der Zähler vor Erreichen dieser Impulszahl n neu durch einen Impuls vom lichtelektrischen Empfänger 220 gesetzt wird. Wenn sich nun beim Ringzähler 521 die logische « 1 » gerade in der dritten Stufe befindet, so liegt am Ausgang der dritten Stufe 5218 beispielsweise ein « high »-Signal an und gibt das UND-Glied 523 frei.

Wenn sich zufällig der Schlitz 28 im Schaltabschnitt C befindet, so ist die Anzahl der Impulse vom Taktgenerator 49 kleiner als die gesetzte Impulszahl n und der Zähler 522 gibt keinen Übertragsimpuls ab, so daß der Ringzähler 521, der sich zufällig in der richtigen Zuordnung zu den Schaltabschnitten befindet, nur durch die Impulse vom lichtelektrischen Empfänger 220 richtig weitergeschoben und nicht korrigiert wird. Wenn sich aber der Ringzähler nicht in der richtigen Zuordnung zu den Schaltabschnitten befindet, so wird, wenn sich wieder die logische « 1 » in der dritten Stufe befindet, aber der Schlitz 28 z. B. im Schaltabschnitt A wie folgt korrigiert :

Die Anzahl der Impulse vom Taktgenerator 49 ist größer als die gesetzte Impulszahl n und der Übertragsimpuls vom Zähler 522 ist dann ein Zusatzimpuls, der über das UND-Glied 523 und das ODER-Glied 524 zum Takteingang 5211 des Ringzählers 521 gelangt und die logische « 1 » in die erste Stufe, die dem Schaltabschnitt A zugeordnet ist, schiebt. Die Korrektur des Ringzählers ist so beendet. Beim Vorliegen des Schaltabschnittes B in der gleichen Stellung der logischen « 1 » in der dritten Stufe werden wie beschrieben zwei Korrekturschritte benötigt.

Da diese Korrekturen beim Einschalten und Einlaufen der gesamten Anordnung erfolgen, so haben sie keinen Einfluß in der Arbeitsphase.

Die Anordnung nach der Fig. 8 hat Vorteile für eine Hardware-Ausführung, während die folgende Anordnung nach Fig. 9, die dem gleichen Zweck dient, mehr Vorteile mit Mitteln eines Rechners hat.

In der Fig. 9 ist bei einem löschbaren Binärzähler 530 der Zähleingang mit dem Taktgenerator 49, dessen Taktfrequenz, wie oben beschrieben, durch nicht näher dargestellte Mittel und Verbindungen mit der Geschwindigkeit des Schlitzes 28 synchronisiert ist, verbunden. Der lichtelektrische Empfänger 220 ist sowohl über ein Verzögerungsglied 531 mit dem Löscheingang des Binärzählers 530 als auch direkt mit einem Übernahmeeingang 5332 eines löschbaren Speichers 533 für binärkodierte Zahlen und außerdem mit den Takteingängen eines ersten, zweiten und dritten Impulsspeichers 534, 535 und 536 sowie mit dem Schaltzeitpunktausgang 5001 verbunden. Die Ergebnisausgänge des Binärzählers 530, deren Anzahl den benötigten signifikanten Bits einer binärkodierten Zahl entsprechen (hier sind beispielsweise vier Leitungen eingezeichnet), sind verbunden sowohl mit ersten Eingängen 5321 eines Komparators 532 für binärkodierte Zahlen als auch mit Ergebniseingängen des Speichers 533 und entsprechend stehen auch Ergebnisausgänge 5333 des Speichers 533 mit zweiten Eingängen des Komparators 532 in Verbindung. Beim Komparator ist ein Ausgang 5323 für « größer als » verbunden mit dem Dateneingang des ersten Impulsspeichers 534 (bei D-Flip-Flop ist das der D-Eingang), ein Ausgang für « gleich » mit dem Dateneingang des zweiten Impulsspeichers 535 und ein Ausgang für « kleiner als » mit dem Dateneingang des dritten Impulsspeichers 536. Bei den Impulsspeichern ist der Ausgang des ersten 534 sowohl mit dem Schaltabschnittausgang A 5002 als auch mit dem Löscheingang des dritten Impulsspeichers 536, der Ausgang des zweiten Impulsspeichers 535 sowohl mit dem Schaltabschnittausgang B 5003 als auch mit dem Löscheingang des ersten Impulsspeichers 534 und der Ausgang des dritten Impulsspeichers 536 sowohl mit dem Schaltabschnittausgang C 5004 als auch mit Löscheingang des zweiten Impulsspeichers 535 verbunden. In der Wirkungsweise der Anordnung nach der Fig. 9 ergibt sich eine weitgehende Ähnlichkeit beim Wirkungsablauf zur Fig. 7 bei den drei Impulsspeichern 534, 535 und 536 bzw. 504, 505 und 506, so daß die dort gegebenen Erläuterungen auch sinngemäß hier gelten. Die Dateneingänge der Impulsspeicher 534, 535 und 536 werden jedoch angesteuert von den drei Ausgängen des Komparators anstelle von den drei lichtelektrischen Empfängern 221, 222 und 223. Als Entscheidungskriterium für die Zuordnung der Ausgangsimpulse des lichtelektrischen Empfängers 220 zu den Schaltzeitpunkten 117, 118 und 119 dient der Vergleich zweier aufeinanderfolgender Binärzahlen in ihren signifikanten Bits, weil diese für die Aufeinanderfolge der Schaltabschnitte A und B gleich sind, aber für die Folge der Schaltabschnitte C auf B die folgende Binärzahl kleiner als die vorhergehende ist und für die Folge der Schaltabschnitte A auf C die folgende Binärzahl größer als die vorhergehende ist. Im Schaltbeispiel wird verzögert kurz nach dem Ende jedes Schaltabschnittes A, B oder C, d. h., nach jedem der Schaltzeitpunkte 117, 118 und 119 der Zählinhalt des Binärzählers 530 gelöscht, jedoch unmittelbar zum Zeitpunkt der Schaltzeitpunkte 117, 118 und 119 vorher in den Speicher 533 übernommen als Binärzahl des jeweils vergangenen Schaltabschnittes, wobei diese Binärzahl jeweils der Länge des betreffenden Schaltabschnittes entspricht. Im folgenden laufenden Schaltabschnitt A oder B oder C wird der Binärzähler 530 vom Taktgenerator 49 gefüllt und der Komparator 532 vergleicht den laufenden Inhalt des Binärzählers 530 mit dem Inhalt des Speichers 533. Dabei kann an den Ausgängen des Komparators 532 nacheinander ein beispielsweises « high »-Signal am Ausgang 5323 für « kleiner als », möglicherweise danach auch am Ausgang für « gleich » oder auch am Ausgang für « größer als » erscheinen, bis der nächste Impuls vom lichtelektrischen Empfänger 220 das « high »-Signal vom jeweils erreichten Ausgang des Komparators 522 in einen der Impulsspeicher 534, 535 oder 536 und damit auf den jeweiligen Schaltabschnittausgang 5002 oder 5003 oder auch 5004 übernimmt.

Die vorstehenden Anordnungen, vor allem diejenigen mit nur einem lichtelektrischen Empfänger 220, sind zwar auf die erfindungsgemäße Anordnung zugeschnitten, sie lassen sich jedoch auch vorteilhaft für übliche Zweistrahlgeräte verwenden, wenn die beschriebenen Bedingungen dafür geschaffen werden.

Für die sichere Gewinnung der beschriebenen signifikanten Bit (da wegen unvermeidlicher Toleranzen bei der Impulszählung die niederwertigen Bit unterdrückt werden müssen, damit der Komparator 532 eine immer eindeutige Aussage liefern kann) ist es gegebenenfalls ratsam, einen günstigen Code für den Ausgang des Binärzählers 530 zu wählen, z. B. den bekannten Gray-Code.

## Patentansprüche

1. Anordnung zur automatischen Justierung eines ersten Gegenstandes, beispielsweise einer Halbleiterscheibe oder eines zweiten Gegenstandes, beispielsweise einer Schablone gegenüber einem lichtelektrischen Mess- und Abtastsystem oder zur Justierung der beiden Gegenstände zueinander und zum Mess- und Abtastsystem, wobei der jeweilige Gegenstand jeweils mit Justiermarken mit mindestens einer Symmetrieachse versehen ist, die von einer Lichtquelle beleuchtet und durch optische Systeme mit einer gemeinsamen optischen Achse auf die Abtastebene des lichtelektrischen Meß- und Abtastsystems abgebildet werden, dessen Bildsignale elektronisch verarbeitet, durch ein Rechenwerk ausgewertet und in Steuersignale für mindestens ein die Justierung besorgendes Stellglied umgesetzt werden, dadurch gekennzeichnet, daß ein erstes Mittel (114) vorhanden ist, das in der Abtastebene (100) des lichtelektrischen Meß- und Abtastsystems (121) einen ersten (115) und einen zweiten (116) durch eine ortsfeste Achse (38) getrennten Bildausschnitt wirksam werden läßt, die im wesentlichen gleich ausgebildet, symmetrisch zur ortsfesten (38) und optischen (9) Achse und parallel zur Symmetrieachse (39) der Justiermarken (4, 5, 7, 8) angeordnet sind, daß im lichtelektrischen Meß- und Abtastsystem ein zweites Mittel (113) vorhanden ist, das eine periodische Bildabtastung senkrecht zur ortsfesten Achse (38) ermöglicht, und daß durch einen mit dem lichtelektrischen Meß- und Abtastsystem verbundenen Schaltzeitpunktdetektor (51) ein erster (117), zweiter (118) und dritter (119) Schaltzeitpunkt vorgegeben ist, zwischen denen die beiden Bildausschnitte (115, 116) abwechselnd zur Bildsignalerzeugung benutzt werden, daß das zweite Mittel (113) mit einem Taktgenerator (49) für die Zeitbasis verbunden ist, daß der Schaltzeitpunktdetektor (51) Bestandteil einer Kanalsteuereinrichtung (50) ist, daß sowohl das Meß- und Abtastsystem (121) als auch die Kanalsteuereinrichtung (50) ausgangsseitig verbunden ist mit einer sequentiellen Bildsignalverarbeitungseinrichtung (60) und daß des Rechenwerk (80) mindestens einen, in zwei Funktionsgruppen (82, 83) betreibbaren Speicher (81) und mindestens eine Arithmetikeinrichtung (90) enthält, deren Ausgang (8005) ein Steuersignal für die Regelabweichung des Stellglieds (26, 27) zu liefern gestattet.

2. Anordnung nach Anspruch 1, dadurch gekennzeichnet, daß das erste Mittel (114) eine lichtundurchlässige Maske (14) mit einem ersten (15) und einem zweiten (16) Bildausbruch ist.

3. Anordnung nach Anspruch 2, dadurch gekennzeichnet, daß das zweite Mittel (113) ein der Maske (14) unmittelbar benachbart angeordneter beweglicher Schlitzträger (13) mit einem Antriebsmotor (45) und dessen Ansteuereinrichtung (46) ist, daß das Meß- und Abtastsystem (121) einen einzigen lichtelektrischen Wandler (21) enthält, der dem Strahlengang mit der optischen Achse (9) für die beiden Bildausbrüche (15, 16) zugeordnet ist und einen Bildsignalausgang (210) besitzt, daß der Schaltzeitpunktdetektor (51) mindestens eine weitere Lichtquelle (42), einen ersten (17), zweiten (18) und dritten (19) ebenfalls auf der Maske (14) angeordneten schlitzartigen Durchbruch, den Schlitzträger (13) und mindestens einen lichtelektrischen Empfänger (22), der einem Strahlengang mit einer optischen Achse (20) für die schlitzartigen Durchbrüche (17, 18, 19) zugeordnet ist, aufweist, wobei die Schlitzrichtung der schlitzartigen Durchbrüche (17, 18, 19) und eines jeweils wirksamen Schlitzes (28) des Schlitzträgers (13) parallel zur ortsfesten Achse (38) verläuft und, daß der jeweils wirksame Schlitz (28) des Schlitzträgers (13) mit einer Laufrichtung (47) versehen ist, die nacheinander den ersten Durchbruch (17), den ersten Bildausbruch (15), den zweiten Durchbruch (18), den zweiten Bildausbruch (16) und den dritten Durchbruch (19) überdeckt.

4. Anordnung nach Anspruch 3, dadurch gekennzeichnet, dass der Schaltzeitpunktdetektor (51) einen ersten (221), zweiten (222) und dritten (223) lichtelektrischen Empfänger mit einem logisch verarbeitbaren Ausgangssignal umfasst, dass ein ODER-Glied (514) vorgesehen ist und daß die Kanalsteuereinrichtung (50) einen ersten (504), zweiten (505) und dritten (506) löschbaren und mit je einem Daten- und Übernahmeeingang versehenen Impulsspeicher, beispielsweise ein D-Flip-Flop enthält, daß der erste lichtelektrische Empfänger (221) sowohl mit dem ersten Eingang des ODER-Gliedes (514), als auch mit dem Dateneingang des ersten Impulsspeichers (504), der zweite lichtelektrische Empfänger (222) sowohl mit dem zweiten Eingang des ODER-Gliedes (514), als auch mit dem Dateneingang des zweiten Impulsspeichers (505), der dritte lichtelektrische Empfänger (223) sowohl mit dem dritten Eingang des ODER-Gliedes (514) als auch mit dem Dateneingang des dritten Impulsspeichers (506), sowie die Übernahmeeingänge des ersten (504), zweiten (505) und dritten (506) Impulsspeichers untereinander und mit dem Ausgang des ODER-Gliedes (514), sowie beim ersten Impulsspeicher (504) der Ausgang sowohl mit dem Löscheingang des dritten Impulsspeichers (506) als auch mit der Verbindungsstelle für einen Schaltabschnittausgang A (5002), sowie beim zweiten Impulsspeicher (505) der Ausgang sowohl mit dem Löscheingang des ersten Impulsspeichers (504) als auch mit der Verbindungsstelle für einen Schaltabschnittausgang B (5003), sowie beim dritten Impulsspeicher (506) der Ausgang sowohl mit dem Löscheingang des zweiten Impulsspeichers (505) als auch mit der Verbindungsstelle für einen Schaltabschnittausgang C (5004), und außerdem der Ausgang des ODER-Gliedes (514) mit der Verbindungsstelle für einen Schaltzeitpunktausgang (5001) verbunden sind.

5. Anordnung nach Anspruch 3, dadurch gekennzeichnet, daß beim Schaltzeitpunktdetektor (51) der Abstand der drei schlitzförmigen Durchbrüche (17, 18, 19) voneinander größer als ein Drittel und kleiner als die Hälfte des Abstandes zweier benachbarter Schlitze des beweglichen Schlitzträgers (13) ist und daß den drei schlitzförmigen Durchbrüchen (17, 18, 19) ein einziger lichtelektrischer Empfänger (220) zugeordnet ist, wobei der lichtelektrische Empfänger ein logisch verarbeitbares Ausgangssignal besitzt.

6. Anordnung nach Anspruch 5, dadurch gekennzeichnet, daß die Kanalsteuereinrichtung (50) einen dreistufigen Ringzähler (521), einen setzbaren Zähler (522), einen dazu passenden Sollwertsteller (520), ein UND-Glied (523) sowie ein ODER-Glied (524) enthält, daß beim setzbaren Zähler (522) ein Zähleingang (5221) mit dem Taktgenerator (49), ein Setzbefehlseingang (5222) mit dem lichtelektrischen Empfänger (220), Setzeingänge (5223) mit dem Sollwertsteller (520) und ein Übertragsimpulsausgang (5224) mit dem einen Eingang des UND-Gliedes (523) sowie beim Ringzähler (521) ein Takteingang (5211) mit dem Ausgang des ODER-Gliedes (524), der Ausgang einer ersten Stufe (5216) mit der Verbindungsstelle für den Schaltabschnittausgang A (5002), der Ausgang einer zweiten Stufe (5217) mit der Verbindungsstelle für den Schaltabschnittausgang B (5003) und der Ausgang einer dritten Stufe (5218) sowohl mit dem anderen Eingang des UND-Gliedes (523) als auch mit der Verbindungsstelle für den Schaltabschnittausgang C (5004) verbunden sind, sowie beim ODER-Glied (524) der eine Eingang sowohl mit dem lichtelektrischen Empfänger (220) als auch mit der Verbindungsstelle für den Schaltzeitpunktausgang (5001) der Kanalsteuereinrichtung (50) und der andere Eingang mit dem Ausgang des UND-Gliedes (523) verbunden sind, und dass die binärkodierte Impulszahl des Sollwertstellers (520) grösser als eine Impulszahl des Taktgenerators (49) zwischen dem dritten (119) und dem ersten (117) Schaltzeitpunkt und kleiner als die Impulszahl des Taktgenerators zwischen dem ersten (117) und dem zweiten (118) Schaltzeitpunkt ist.

7. Anordnung nach Anspruch 5, dadurch gekennzeichnet, daß in der Kanalsteuereinrichtung (50) ein löschbarer Binärzähler (530), ein Verzögerungsglied (531), ein Komparator (532) für binärkodierte Zahlen und mit Ausgängen für « größer als », « gleich » und « kleiner als », ein löschbarer Speicher (533) für binärkodierte Zahlen sowie ein erster (534), ein zweiter (535) und ein dritter (536) löschbarer und mit je einem Daten- und Übernahmeeingang versehener Impulsspeicher, beispielsweise ein D-Flip-Flop, enthalten sind, daß beim löschbaren Binärzähler (530) der Zähleingang mit dem Taktgenerator (49), der Löscheingang über das Verzögerungsglied (531) mit dem lichtelektrischen Empfänger (220) und die Ergebnisausgänge sowohl mit ersten Eingängen (5321) des Komparators (532) als auch mit den Ergebniseingängen des Speichers (533), sowie beim Speicher (533) ein Übernahmeeingang (5332) mit dem lichtelektrischen Empfänger (220) und Ergebnisausgänge (5333) mit den zweiten Eingängen des Komparators (532), sowie beim Komparator (532) ein Ausgang für « größer als » (5323) mit dem Dateneingang des ersten Impulsspeichers (534), der Ausgang für « gleich » mit dem Dateneingang des zweiten Impulsspeichers (535) und der Ausgang für « kleiner als » mit dem Dateneingang des dritten Impulsspeichers (536), sowie beim ersten Impulsspeicher (534) der Takteingang sowohl mit dem Takteingang des zweiten Impulsspeichers (535) als auch mit dem Takteingang des dritten Impulsspeichers (536) und auch mit dem lichtelektrischen Empfänger (220) und dazu mit der Verbindungsstelle für den Schaltzeitpunktausgang (5001) und der Ausgang des ersten Impulsspeichers (534) sowohl mit dem Löscheingang des dritten Impulsspeichers (536) als auch mit der Verbindungsstelle für den Schaltabschnittausgang A (5002), sowie beim zweiten Impulsspeicher (535) der Ausgang sowohl mit dem Löscheingang des ersten Impulsspeichers (534) als auch mit der Verbindungsstelle für den Schaltabschnittausgang B (5003) sowie beim dritten Impulsspeicher (536) der Ausgang sowohl mit dem Löscheingang des zweiten Impulsspeichers (535) als auch mit der Verbindungsstelle für den Schaltabschnittausgang C (5004) verbunden sind.

8. Anordnung nach Anspruch 1, dadurch gekennzeichnet, dass das lichtelektrische Mess- und Abtastsystem (121) eine Fernsehkamera (215) ist, wobei das zweite Mittel (113) eine an sich bekannte Spaltenablenkeinheit (233) ist, dass diese sowie die übliche Zeilenablenkeinheit (234) einen jeweils zugehörigen Spalten- (225) bzw. Zeilen- (226) Sägezahngenerator enthält, wobei die Richtung (47) der Spaltenablenkung rechtwinklig zur ortsfesten Achse (38) verläuft, daß die Kanalsteuereinrichtung. (50) aus einem ersten (541), zweiten (542) und dritten (543) Komparator, der jeweils zusätzlich einen negierten Ausgang besitzt, einem ersten (544), zweiten (545), dritten (546) und vierten (547) NAND-Glied, einem UND-Glied (548), einem NOR-Glied (549) und einem Mehrfachvergleichswert-steller (540) mit je einem ersten, vierten und siebenten Spannungsanschluß in steigender Folge für je einen Komparator besteht, daß der Spaltensägezahngenerator (225) sowie der Zeilensägezahngenerator (226) synchronisiert mit dem Taktgenerator (49), und der erste, vierte und siebente Spannungsanschluß des Mehrfachvergleichswertstellers (540) in steigender Folge mit dem jeweils ersten Eingang des ersten (541), des zweiten (542) und des dritten (543) Komparators, und jeder der zweiten Eingänge des ersten (541), des zweiten (542) und des dritten (543) Komparators untereinander und mit einem stromabhängigen Anschluß der Spaltenablenkeinheit (233) und, der eine Eingang des ersten NAND-Gliedes (544) mit dem negierten Ausgang des ersten Komparators (541) und, der andere Eingang des ersten NAND-Gliedes (544) mit den nicht negierten Ausgang des zweiten Komparators (542) und der eine Eingang des zweiten NAND-Gliedes (545) mit dem negierten Ausgang des zweiten Komparators (542) und der Ausgang des ersten NAND-Gliedes (544) sowohl mit dem einen Eingang des UND-Gliedes (548) als auch mit den Eingängen des dritten NAND-Gliedes (546) und der Ausgang des zweiten NAND-Gliedes (545) sowohl mit dem anderen Eingang des UND-Gliedes (544) als auch mit den Eingängen des vierten NAND-Gliedes (547) und der Ausgang des dritten NAND-Gliedes (546) sowohl mit dem ersten Eingang des NOR-Gliedes (549) als auch mit der Verbindungsstelle für Schaltabschnittausgang A (5002) und der Ausgang des vierten NAND-Gliedes (547) sowohl mit dem zweiten Eingang des NOR-Gliedes (549) als auch mit der Verbindungsstelle für den Schaltabschnittausgang B (5003) und der Ausgang des UND-Gliedes (548) sowohl mit dem dritten Eingang des NOR-Gliedes (549) als auch mit der Verbindungsstelle für den Schaltabschnittausgang C (5004) und der Ausgang des NOR-Gliedes (549) mit der Verbindungsstelle für den Schaltzeitpunktausgang (5001) verbunden sind.

9. Anordnung nach Anspruch 8, dadurch gekennzeichnet, daß das erste Mittel (114) eine Analogsignaltorschaltung (240) ist, die einen sperrbaren Analogsignalkanal mit einem Eingang (2401) und einem Ausgang (2402) und einen Sperreingang (2403) besitzt, daß bei der Analogsignaltorschaltung (240) der Eingang (2401) mit dem Bildsignalausgang der Fernsehkamera (225) und der Ausgang (2402) mit der Verbindungsstelle für einen Ausgang (211) für das analoge Bildsignal des lichtelektrischen Meß- und Abtastsystems (121) verbunden ist, daß zum ersten Mittel (114) in Verbindung mit der Kanalsteuereinrichtung (50) ein vierter bis neunter Komparator (551 bis 556) mit jeweils einem zusätzlich negierten Ausgang, ein ODER-Glied (550), ein zweites (557) und drittes (558) UND-Glied und weitere Spannungsanschlüsse des Mehrfachvergleichswertstellers (540), von denen ein zweiter und dritter in steigender Folge zwischen dem ersten und vierten Spannungsanschluß, ein fünfter und sechster zwischen dem vierten und siebenten Spannungsanschluß jeweils symmetrisch zum vierten Spannungsanschluß und ebenso symmetrisch dazu ein achter und neunter Spannungsanschluß angeordnet sind, gehören, daß von den Mehrfachsvergleichswertsteller (540) der zweite Spannungsanschluß mit dem ersten Eingang des vierten Komparators (551), der dritte Spannungsanschluß mit dem ersten Eingang des fünften Komparators (552), der fünfte Spannungsanschluß mit dem ersten Eingang des sechsten Komparators (553), der sechste Spannungsanschluß mit dem ersten Eingang des siebenten Komparators (554), der achte Spannungsanschluß mit dem ersten Eingang des achten Komparators (555), der neunte Spannungsanschluß mit dem ersten Eingang des neunten Komparators (556), und jeder der zweiten Eingänge des vierten (551), des fünften (552), des sechsten (553) und siebenten (554) Komparators mit dem stromabhängigen Anschluß der Spaltenablenkeinheit (233), und jeder der zweiten Eingänge des achten (555) und neunten (556) Komparators mit einem stromabhängigen Anschluß der Zeilenablenkeinheit (234) und beim zweiten UND-Glied (557) der eine Eingang mit dem negierten Ausgang des vierten Komparators (551), der andere Eingang mit dem nicht negierten Ausgang des fünften Komparators (552) und der Ausgang mit dem ersten Eingang des ODER-Gliedes (550) verbunden sind, und daß beim dritten UND-Glied (558) der eine Eingang mit dem negierten Ausgang des sechsten Komparators (553), der andere Eingang mit dem nicht negierten Ausgang des siebenten Komparators (554) und der Ausgang mit dem zweiten Eingang des ODER-Gliedes (550), beim vierten UND-Glied (559) der eine Eingang mit dem negierten Ausgang des achten Komparators (555), der andere Eingang mit dem nicht negierten Ausgang des neunten Komparators (556) und der Ausgang mit dem dritten Eingang des ODER-Gliedes (550) und der Ausgang des ODER-Gliedes (550) mit dem Sperreingang (2403) der Analogsignaltorschaltung (240) verbunden sind.

10. Anordnung nach Anspruch 1, dadurch gekennzeichnet, daß die Justiermarken des zweiten Gegenstandes (2) als ein Paar untereinander gleicher Schablonenfenster (7, 8) ausgebildet sind, die symmetrisch zu einer Schablonenfensterpaarachse (40) liegen und durch einen lichtundurchlässigen Zwischensteg getrennt sind, daß dieses Schablonenfensterpaar (7, 8) auf die Justiermarken (4, 5) des ersten Gegenstandes (1) und mit diesem zusammen auf die Abtastebene (100) des lichtelektrischen Meß- und Abtastsystems (121) so abgebildet wird, daß die Schablonenfensterpaarachse (40) und die ortsfeste Achse (38) im wesentlichen parallel verlaufen, daß in Richtung der Schablonenfensterpaarachse (40) die Abbildung der Schablonenfensterbilder (7', 8') in der Abtastebene (100) größer als die Ausdehnung der Bildausschnitte (115, 116) und rechtwinklig zur Schablonenfensterpaarachse (40) kleiner als die Ausdehnung der Bildausschnitte (115, 116) ist, daß ein erstes Stellglied (26) zur Justierung des ersten Gegenstandes (1) und ein zweites Stellglied (27) zur Justierung des zweiten Gegenstandes (2) zum lichtelektrischen Meß- und Abtastsystem (121) und eine steuerbare Antriebsartenweiche (25) vorhanden sind, deren beide Ausgänge zur Abgabe von Steuersignalen jeweils mit dem ersten (26) und dem zweiten (27) Stellglied, deren Signaleingang mit dem Ausgang (8005) des Rechenwerkes und deren Steuereingang mit einer Betriebsartenwahleinrichtung (24) verbunden sind.

11. Anordnung nach Anspruch 10, dadurch gekennzeichnet, daß die sequentielle Bildsignalverarbeitungseinrichtung (60) und das Rechenwerk (80) zur Strukturerkennung und zur Lagebestimmung dunkler Bildelemente eingerichtet sind, daß die sequentielle Bildsignalverarbeitungseinrichtung (60) einen Bildsignalkomparator (620), einen Bildpegeleinsteller (621), ein als Negator (622) dienendes NAND-Glied, ein als Umschalter (623) dienendes NAND-Glied, ein als Tor (624) dienendes UND-Glied, ein als Taktkomparator (625) dienendes UND-Glied und ein ODER-Glied (626) enthält, daß beim Bildsignalkomparator der eine Eingang mit dem Bildpegeleinsteller (621), der andere Eingang mit dem Ausgang (211) für das analoge Bildsignal der lichtelektrischen Meß- und Abtasteinrichtung (12-1) und der Ausgang sowohl mit dem einen Eingang des Negators (622) als auch mit dem einen Eingang des Tores (624) und beim Umschalter (623) der Eingang sowohl mit der Betriebsartenwahleinrichtung (24) als auch mit dem anderen Eingang des Tores (624) und der Ausgang mit dem anderen Eingang des Negators (622) und beim ODER-Glied (626) der eine Eingang mit dem Ausgang des Negators (622), der andere Eingang mit dem Ausgang des Tores (624) und der Ausgang sowohl mit einem ersten Rechenwerkseingang (8001) für das binäre Bildsignal als auch mit dem einen Eingang des Taktkomparators (625) und beim Taktkomparator (625) der andere Eingang mit dem Taktgenerator (49) und der Ausgang mit einem zweiten Rechenwerkseingang (8002) für den Bildsignaltakt so verbunden sind, daß in der Schaltstellung für die Justierung des ersten Gegenstandes (1) zum zweiten Gegenstand (2) der Ausgang des Bildsignalkomparators (620) direkt mit dem ersten Rechenwerkseingang (8001) und in der Schaltstellung für die Justierung des zweiten Gegenstandes (2) zum lichtelektrischen Meß- und Abtastsystem (121) der Ausgang des Bildsignalkomparators (620) über den Negator (622) mit dem ersten Rechenwerkseingang (8001) verbunden sind.

**Claims**

1. Arrangement for the automatic adjustment of a first object, e. g. a semi-conductor wafer, or of a second object, e. g. a template, relative to a photoelectric measuring and scanning system, or for the adjustment of the two objects relative to one another and to the measuring and scanning system, the respective object being provided in each case with adjusting marks having at least one symmetry axis, which marks are illuminated by a light source and projected through optical systems having a common optical axis onto the scanning plane of the photoelectric measuring and scanning system, the image signals of which are electronically processed, evaluated by an arithmetic unit, and converted into control signals for at least one regulating unit carrying out the adjustment, characterized in that there is a first means (114) which causes a first (115) and a second (116) image sector, separated by a stationary axis (38), to become effective in the scanning plane (100) of the photoelectric measuring and scanning system (121), which image sectors are substantially identically formed and disposed symmetrically to the stationary (38) and optical (9) axes and parallel to the symmetry axis (39) of the adjusting marks (4, 5, 7, 8), that there is in the photoelectric measuring and scanning system a second means (113) which makes possible a periodic image-scanning perpendicular to the stationary axis (38), and that by means of a switching-time detector (51) connected to the photoelectric measuring and scanning system, a first (117), second (118), and third (119) switching time are given, between which the two image sectors (115, 116) are alternately used for generating image signals, that the second means (113) is connected to a clock (49) for the time base, that the switching-time detector (51) is part of a channel control unit (50), that both the measuring and scanning system (121) and the channel control unit (50) are connected on the output side to a sequential image-signal processing unit (60), and that the arithmetic unit (80) contains at least one memory (81) operable in two functional groups (82, 83) and at least one arithmetic element (90), the output (8005) of which allows a control signal for the deviation of the regulating unit (26, 27) to be supplied.

2. Arrangement according to claim 1, characterized in that the first means (114) is an opaque mask (14) having a first (15) and a second (16) image cut-out.

3. Arrangement according to claim 2, characterized in that the second means (113) is a movable slot-carrier (13) disposed immediately adjacent to the mask (14), having a driving motor (45) and its control device (46), that the measuring and scanning system (121) contains a single photoelectric transducer (21) which is associated with the beam path having the optical axis (9) for the two image cut-outs (15, 16) and has an image-signal output (210), that the switching-time detector (51) has at least one further light source (42), a first (17), second (18), and third (19) slot-shaped perforation likewise disposed on the mask (14), the slot-carrier (13), and at least one photoelectric receiver (22) which is associated with a beam path having an optical axis (20) for the slot-shaped perforations (17, 18, 19), the slot-direction of the slot-shaped perforations (17, 18, 19) and of whichever slot (28) of the slot-carrier (13) is effective at any given time running parallel to the stationary axis (38), and that the slot (28) of the slot-carrier (13) effective at any given time is provided with a running direction (47) which successively covers the first perforation (17), the first image cut-out (15), the second perforation (18), the second image cut-out (16), and the third perforation (19).

4. Arrangement according to claim 3, characterized in that the switching-time detector (51) comprises a first (221), second (222), and third (223) photoelectric receiver having a logically processable output signal, that an OR-element (514) is provided for, and that the channel control unit (50) contains a first (504), second (505), and third (506) erasable pulse store, e. g. a D flip-flop, each provided with a data and a transfer input, that the first photoelectric receiver (221) is connected both to the first input of the OR-element (514) and to the data input of the first pulse store (504), the second photoelectric receiver (222) is connected both to the second input of the OR-element (514) and to the data input of the second pulse store (505), the third photoelectric receiver (223) is connected both to the third input of the OR-element (514) and to the data input of the third pulse store (506), and the transfer inputs of the first (504), second (505), and third (506) pulse stores are interconnected and connected to the output of the OR-element (514), and in the first pulse store (504) the output is connected both to the erasing input of the third pulse store (506) and to the junction for a switching-interval output A (5002), and in the second pulse store (505) the output is connected both to the erasing input of the first pulse store (504) and to the junction for a switching-interval output B (5003), and in the third pulse store (506) the output is connected both to the erasing input of the second pulse store (505) and to the junction for a switching-interval output C (5004), and besides the output of the OR-element (514) is connected to the junction for a switching-time output (5001).

5. Arrangement according to claim 3, characterized in that in the switching-time detector (51) the spacing of the three slot-shaped perforations (17, 18, 19) from one another is greater than one-third and smaller than one-half of the spacing of two adjacent slots of the movable slot-carrier (13), and that a single photoelectric receiver (220) is associated with the three slot-shaped perforations (17, 18, 19), the photoelectric receiver having a logically processable output signal.

6. Arrangement according to claim 5, characterized in that the channel control unit (50) contains a three-stage ring counter (521), a settable counter (522), a set-point adjuster (520) suitable thereto, an AND-element (523), as well as an OR-element (524), that in the settable counter (522) a counting input (5221) is connected to the clock (49), a set-command input (5222) is connected to the photoelectric receiver (220), setting inputs (5223) are connected to the set-point adjuster (520), and a carry-pulse output (5224) is connected to one input of the AND-element (523), and in the ring counter (521) a clock input (5211) is connected to the output of the OR-element (524), the output of a first stage (5216) is connected to the junction for the switching-interval output A (5002), the output of a second stage (5217) is connected to the junction for the switching-interval output B (5003), and the output of a third stage (5218) is connected both to the other input of the AND-element (523) and to the junction for the switching-interval output C (5004), and in the OR-element (524) one input is connected both to the photoelectric receiver (220) and to the junction for the switching-time output (5001) of the channel control unit (50) and the other input to the output of the AND-element (523), and that the binary coded pulse count of the set-point adjuster (520) is greater than a number of pulses of the clock (49) between the third (119) and the first (117) switching time and less than the number of pulses of the clock between the first (117) and the second (118) switching time.

7. Arrangement according to claim 5, characterized in that in the channel control unit (50) an erasable binary counter (530), a delay element (531), a comparator (532) for binary coded numbers and having outputs for « greater than », « equal to », and « less than », an erasable memory (533) for binary coded numbers, as well as a first (534), a second (535), and a third (536) erasable pulse store, e. g. a D flip-flop, each provided with a data and a transfer input, are contained, that in the erasable binary counter (530) the counting input is connected to the clock (49), the erasing input is connected via the delay element (531) to the photoelectric receiver (220), and the result outputs are connected to both to first inputs (5321) of the comparator (532) and to the result inputs of the memory (533), and in the memory (533) a transfer input (5332) is connected to the photoelectric receiver (220), and result outputs (5333) are connected to the second inputs of the comparator (532), and in the comparator (532) an output for « greater than » (5323) is connected to the data input of the first pulse store (534), the output for « equal to » to the data input of the second pulse store (535), and the output for « less than » to the data input of the third pulse store (536), and in the first pulse store (534) the clock input is connected both to the clock input of the second pulse store (535) and to the clock input of the third pulse store (536) and also to the photoelectric receiver (220) and additionally to the junction for the switching-time output (5001), and the output of the first pulse store (534) is connected both to the erasing input of the third pulse store (536) and to the junction for the switching-interval output A (5002), and in the second pulse store (535) the output is connected both to the erasing input of the first pulse store (534) and to the junction for the switching-interval output B (5003), and in the third pulse store (536) the output is connected both to the erasing input of the second pulse store (535) and to the junction for the switching-interval output C (5004).

8. Arrangement according to claim 1, characterized in that the photoelectric measuring and scanning system (121) is a television camera (215), the second means (113) being a column scanning unit (233) known *per se,* that this unit, as well as the usual line scanning unit (234), contains a respectively associated column saw-tooth generator (225) and line saw-tooth generator (226), the direction (47) of the column scanning running at right angles to the stationary axis (38), that the channel control unit (50) consists of a first (541), second (542), and third (543) comparator, each of which additionally has a negated output, a first (544), second (545), third (546), and fourth (545) NAND-element, an AND-element (548), a NOR-element (549), and a multiple comparative-value generator (540) having a first, fourth, and seventh voltage terminal in ascending order for one comparator each, that the column saw-tooth generator (225) and the line saw-tooth generator (226) are synchronized with the clock (49), and the first, fourth, and seventh voltage terminals of the multiple comparative-value generator (540) are connected to in ascending order to the first input in each case of the first (541), the second (542), and the third (543) comparator, and each of the second inputs of the first (541), the second (542), and the third (543) comparator are connected to one another and to a current-dependent connection of the column scanning unit (233), and one input of the first NAND-element (544) is connected to the negated output of the first comparator (541), and the other input of the first NAND-element (544) is connected to the non-negated output of the second comparator (542), and one input of the second NAND-element (545) is connected to the negated output of the second comparator (542), and the output of the first NAND-element (544) is connected both to one input of the AND-element (548) and to the inputs of the third NAND-element (546), and the output of the second NAND-element (545) is connected both to the other input of the AND-element (544) and to the inputs of the fourth NAND-element (547), and the output of the third NAND-element (546) is connected both to the first input of the NOR-element (549) and to the junction for switching-interval output A (5002), and the output of the fourth NAND-element (547) is connected both to the second input of the NOR-element (549) and to the junction for the switching-interval output B (5003), and the output of the AND-element (548) is connected both to the third input of the NOR-element (549) and to the junction for the switching-interval output C (5004), and the output of the NOR-element (549) is connected to the junction for the switching-time output (5001).

9. Arrangement according to claim 8, characterized in that the first means (114) is an analog signal gate circuit (240) having an inhibitable analog signal channel with an input (2401) and an output (2402) and an inhibiting input (2403), that in the analog signal gate circuit (240) the input (2401) is connected to the video-signal output of the television camera (225), and the output (2402) is connected to the junction for an output (211) for the analog image signal of the photoelectric measuring and scanning system (121), that the first means (114) in combination with the channel control unit (50) includes fourth to ninth comparators (551 to 556), each having an additionally negating output, an OR-element (550), a second (557) and third (558) AND-element, and further voltage terminals of the multiple comparative-value generator (540) of which a second and third are disposed is ascending order between the first and fourth voltage terminals, a fifth and sixth between the fourth and seventh voltage terminals symmetrically to the fourth voltage terminal in each case, and likewise symmetrically thereto an eight and ninth voltage terminal, that of the multiple comparative-value generator (540) the second voltage terminal is connected to the first input of the fourth comparator (551), the third voltage terminal is connected to the first input of the fifth comparator (552), the fifth voltage terminal is connected to the first input of the sixth comparator (553), the sixth voltage terminal is connected to the first input of the seventh comparator (554), the eighth voltage terminal is connected to the first input of the eighth comparator (555), the ninth voltage terminal is connected to the first input of the ninth comparator (556), and each of the second inputs of the fourth (551), the fifth (552), the sixth (553), and seventh (554) comparators is connected to the current-dependent connection of the column scanning unit (233), and each of the second inputs of the eighth (555) and ninth (556) comparators is connected to a current-dependent connection of the line scanning unit (234), and in the second AND-element (557) one input is connected to the negated output of the fourth comparator (551), the other input is connected to the non-negated output of the fifth comparator (552), and the output is connected to the first input of the OR-element (550), and that in the third AND-element (558) one input is connected to the negated ouput of the sixth comparator (553), the other input is connected to the non-negated output of the seventh comparator (554), and the ouput is connected to the second input of the OR-element (550), in the fourth AND-element (559) one input is connected to the negated output of the eighth comparator (555), the other input is connected to the non-negated output of the ninth comparator (556), and the output is connected to the third input of the OR-element (550), and the output of the OR-element (550) is connected to the inhibiting input (2403) of the analog signal gate circuit (240).

10. Arrangement according to claim 1, characterized in that the adjusting marks of the second object (2) take the form of a pair of identical template apertures (7, 8) situated symmetrically relative to a template aperture-pair axis (40) and separated by an opaque intermediate web, that this pair of template apertures (7, 8) is so projected on the adjusting marks (4, 5) of the first object (1) and, together with the latter, on the scanning plane (100) of the photoelectic measuring and scanning system (121) that the template aperture-pair axis (40) and the stationary axis (38) run substantially parallel, that in the direction of the template aperture-pair axis (40) the projection of the template aperture images (7', 8') in the scanning plane (100) is greater than the extent of the image sectors (115, 116), and at right angles to the template aperture-pair axis (40) is smaller than the extent of the image sectors (115, 116), that there are a first regulating unit (26) for adjusting the first object (1) and a second regulating unit (27) for adjusting the second object (2) relative to the photoelectric measuring and scanning system (121) and a controllable drive-mode switching device (25) of which the two outputs are respectively connected to the first (26) and the second (27) regulating unit for transmitting control signals, the signal input to the output (8005) of the arithmetic unit, and the control input to an operating-mode selection unit (24).

11. Arrangement according to claim 10, characterized in that the sequential image-signal processing unit (60) and the arithmetic unit (80) are arranged for the pattern recognition and for the determination of position of dark image elements, that the sequential image-signal processing unit (60) contains an image-signal comparator (620), an image-level adjuster (621), a NAND-element serving as a negator (622), a NAND-element serving as a changeover switch (623), an AND-element serving as a gate (624), an AND-element serving as a clock comparator (625), and an OR-element (626), that in the image-signal comparator one input is connected to the image-level adjuster (621), the other input is connected to the output (211) for the analog image signal of the photoelectric measuring and scanning system (121), and the output is connected both to one input of the negator (622) and to one input of the gate (624), and in the changeover switch (623) the input is connected both to the operating-mode selection unit (24) and to the other input of the gate (624), and the output is connected to the other input of the negator (622), and in the OR-element (626) one input is connected to the output of the negator (622), the other input is connected to the output of the gate (624), and the output is connected both to a first arithmetic-unit input (8001) for the binary image signal and to one input of the clock comparator (625), and in the clock comparator (625) the other input is connected to the clock (49), and the output is connected to a second arithmetic-unit input (8002) for the image-signal clock pulse, in such a way that in the switch position for the adjustment of the first object (1) relative to the second object (2) the output of the image-signal comparator (620) is connected directly to the first arithmetic unit input (8001), and in the switch position for the adjustment of the second object (2) relative to the photoelectric measuring and scanning system (121) the output of the image-signal comparator (620) is connected via the negator (622) to the first arithmetic unit input (8001).

**Revendications**

1. Dispositif pour l'ajustement automatique d'un premier objet, par exemple d'un disque semi-conducteur ou d'un second objet, par exemple d'un gabarit, par rapport à un système de mesure et de lecture photo-électrique, ou pour l'ajustement des deux objets l'un par rapport à l'autre et par rapport au système de mesure et de lecture, l'objet respectif comportant chaque fois des repères d'ajustement ayant au moins un axe de symétrie, lesquels repères sont éclairés par une source lumineuse et projetés à travers des systèmes optiques ayant un axe optique commun sur le plan de lecture du système de mesure et de lecture photo-électrique dont le signal image est traité électroniquement, est exploité par une unité de calcul et est transformé en signaux de commande pour au moins un organe de commande qui assure l'ajustement, caractérisé en ce qu'il comprend un premier moyen (114) qui rend effectifs un premier (115) et un second (116) secteurs d'image, séparés par un axe fixe (38), dans le plan de lecture (100) du système de mesure et de lecture photo-électrique (121), lesquels secteurs d'image sont substantiellement formés similairement, sont disposés symétriquement à l'axe fixe (38) et optique (9) et parallèlement à l'axe de symétrie (39) des repères d'ajustement (4, 5, 7, 8), en ce qu'il comprend dans le système de mesure et de lecture photoélectrique un second moyen (113) qui permet une lecture périodique d'image perpendiculairement à l'axe fixe (38), et en ce qu'un premier (117), un second (118) et un troisième (119) instant de commutation est prédéterminé par un détecteur d'instant de commutation (51) relié au système de mesure et de lecture photo-électrique, entre lesquels instants les deux secteurs d'image (115, 116) sont utilisés alternativement pour la production de signaux-image, en ce que le second moyen (113) est relié à un générateur de cadencement (49) pour la base des temps, en ce que le détecteur d'instant de commutation (51) est un élément d'une unité de commande de canaux (50), en ce que le système de mesure et de lecture (121) ainsi que l'unité de commande de canaux (50) sont reliés, à leur sortie, à une unité de traitement séquentiel du signal-image (60), et en ce que l'unité de calcul (80) contient au moins une mémoire (81) exploitable en deux groupes de fonctions (82, 83) et au moins une unité arithmétique (90) dont la sortie (8005) permet de fournir un signal de commande pour l'écart de réglage de l'organe de commande (26, 27).

2. Dispositif selon la revendication 1, caractérisé en ce que le premier moyen (114) est un masque opaque (14) avec une première (15) et une seconde (16) découpes pour image.

3. Dispositif selon la revendication 2, caractérisé en ce que le second moyen (113) est un support à fentes (13) mobile placé directement à proximité du masque (14), avec un moteur d'entraînement (45) et le dispositif de commande (46) de celui-ci, en ce que le système de mesure et de lecture (121) contient un seul convertisseur photo-électrique (21), lequel est associé à la marche du rayon d'axe optique (9) pour les deux découpes pour image (15, 16), et comprend une sortie signal-image (210), en ce que le détecteur d'instant de commutation (51) comprend au moins une autre source de lumière (42), une première (17), seconde (18) et troisième (19) ouvertures en forme de fentes également disposées sur le masque (14), le support à fentes (13) et au moins un récepteur photo-électrique (22) qui est associé à la marche d'un rayon d'axe optique (20) pour les ouvertures (17, 18, 19), en forme de fentes du support à fentes (13), et d'une fente (28) du support à fentes (13) étant parallèle à l'axe fixe (38), et en ce que la fente (28) du support à fentes (13) alors effective à un moment donné est pourvue d'une direction de marche (47) qui recouvre successivement la première ouverture (17), la première découpe pour image (15), la seconde ouverture (18), la seconde découpe pour image (16) et la troisième ouverture (19).

4. Dispositif selon la revendication 3, caractérisé en ce que le détecteur d'instant de commutation (51) comprend un premier (221), un second (222) et un troisième (223) récepteurs photo-électriques ayant un signal de sortie pouvant être traité logiquement, qu'un élément -OU (514) est prévu et en ce que l'unité de commande de canaux (50) comprend une première (504), une seconde (505) et une troisième (506) mémoires d'impulsions effaçables, par exemple un flip-flop D, et pourvue chacune d'une entrée de données et d'un transfert de données, en ce que le premier récepteur photo-électrique (221) est relié à la fois à la première entrée de l'élément -OU (514) et à l'entrée de données de la première mémoire d'impulsions (504), le second récepteur photo-électrique (222) est relié à la fois à la seconde entrée de l'élément -OU (514) et à l'entrée de données de la seconde mémoire d'impulsions (505), le troisième récepteur photo-électrique (223) est relié à la fois à la troisième entrée de l'élément -OU (514) et à l'entrée de données de la troisième mémoire d'impulsions (506), de même que les entrées de transfert de la première (504), seconde (505) et troisième (506) mémoires d'impulsions sont reliées entre elles et à la sortie de l'élément -OU (514), de même que chez la première mémoire d'impulsions (504), la sortie est reliée à la fois à l'entrée d'annulation de la troisième mémoire d'impulsions (506) et à la borne de liaison pour une sortie d'intervalle de commutation A (5002), de même que chez la seconde mémoire d'impulsions (505) la sortie est reliée à la fois à l'entrée d'annulation de la première mémoire d'impulsions (504) et à la borne de liaison pour une sortie d'intervalle de commutation B (5003), de même qu'à la troisième mémoire d'impulsions (506) la sortie est reliée à la fois à l'entrée d'annulation et la seconde mémoire d'impulsions (505) et à la borne de liaison pour une sortie d'intervalle de commutation C (5004), et qu'en outre la sortie de l'élément -OU (514) est reliée à la borne de liaison pour une sortie d'instant de commutation (5001).

5. Dispositif selon la revendication 3, caractérisé en ce que la distance entre les trois ouvertures (17, 18, 19) en forme de fentes dans le détecteur d'instant de commutation (51) est supérieure au tiers et inférieure à la moitié de la distance entre deux fentes voisines du support à fentes (13) mobile et en ce qu'un seul récepteur photo-électrique (220) est associé aux trois ouvertures (17, 18, 19) en forme de fentes, le récepteur photo-électrique comprenant un signal de sortie pouvant être traité logiquement.

6. Dispositif selon la revendication 5, caractérisé en ce que l'unité de commande de canaux (50) contient un compteur annulaire (521) à trois étages, un compteur positionnable (522), un appareil à fixer une valeur de consigne (520) approprié, et un élément -ET (523) ainsi qu'un élément -OU (524), en ce que chez le compteur positionnable (522) une entrée de comptage (5221) est reliée au générateur de cadencement (49), une entrée de commande de positionnement (5222) est reliée au récepteur photo-électrique (220), des entrées de positionnement (5223) sont reliées à l'appareil à fixer la valeur de consigne (520), et une sortie d'impulsions de report (5224) est reliée à une entrée de l'élément -ET (523), de même que chez le compteur annulaire (521) une entrée de cadencement (5211) est reliée à la sortie de l'élément -OU (524), la sortie d'un premier étage (5216) est reliée à la borne de liaison pour la sortie d'intervalle de commutation A (5002), la sortie d'un second étage (5217) est reliée à la borne de liaison pour la sortie d'intervalle de commutation B (5003), et la sortie d'un troisième étage (5218) est reliée à la fois à l'autre entrée de l'élément -ET (523) et à la borne de liaison pour la sortie d'intervalle de commutation C (5004), de même que chez l'élément -OU (524), une entrée est reliée à la fois au récepteur photo-électrique (220) et à la borne de liaison pour la sortie d'instant de commutation (5001) de l'unité de commande de canaux (50), et l'autre entrée est reliée à la sortie de l'élément -ET (523), et en ce que le relevé du nombre d'impulsions en code binaire de l'appareil à fixer la valeur de consigne (520) est plus grand que le nombre d'impulsions du générateur à cadencement (49) entre le troisième (119) et le premier (117) instant de commutation et est plus petit que le nombre d'impulsions du générateur de candencement entre le premier (117) et le second (118) instant de commutation.

7. Dispositif selon la revendication 5, caractérisé en ce que l'unité de commande de canaux (50) contient un compteur binaire (530) effaçable, un élément de retard (531), un comparateur (532) pour les nombres en code binaire et ayant des sorties pour « plus grand que », « égal » et « plus petit que », une mémoire effaçable (533) pour les nombres en code binaire, ainsi qu'une première (534), une·seconde (535) et une troisième (536) mémoire à impulsions effaçables, par exemple un flip-flop D et pourvue chacune d'une entrée de données et de transfert, en ce que chez le compteur binaire effaçable (530) l'entrée de comptage est reliée au générateur de cadencement (49), l'entrée d'annulation est reliée au récepteur photo-électrique (220) via l'élément à retard (531), et les sorties de résultats sont reliées à la fois aux premières entrées (5321) du comparateur (532) et aux entrées de résultats de la mémoire (533), de même que chez la mémoire (533) une entrée de transfert (5332) est reliée au récepteur photo-électrique (220), et les sorties de résultats (5333) sont reliées aux secondes entrées du comparateur (532), de même que chez le comparateur (532) une sortie pour « plus grand que » (5323) est reliée à l'entrée de données de la première mémoire à impulsions (534), la sortie pour « égal » est reliée à l'entrée de données de la seconde mémoire à-impulsions (535), et la sortie pour « plus petit que » est reliée à l'entrée de données de la troisième mémoire (536), de même que chez la première mémoire à impulsions (534) l'entrée de cadencement est reliée à la fois à l'entrée de cadencement de la seconde mémoire à impulsions (535) et à l'entrée de cadencement de la troisième mémoire à impulsions (536) ainsi qu'au récepteur photo-électrique (220) et en outre à la borne de liaison pour la sortie d'instants de commutation (5001), et la sortie de la première mémoire à impulsions (534) est reliée à la fois à l'entrée d'annulation de la troisième mémoire à impulsions (536) et à la borne de liaison pour la sortie d'intervalle de commutation A (5002), de même que chez la seconde mémoire à impulsions (535) la sortie est reliée à la fois à l'entrée d'annulation de la première mémoire à impulsions (534) et à la borne de liaison pour la sortie d'intervalle de commutation B (5003), de même que chez la troisième mémoire à impulsions (536) la sortie est reliée à la fois à l'entrée d'annulation et la seconde mémoire à impulsions (535) et à la borne de liaison pour la sortie d'intervalle de commutation C (5004).

8. Dispositif selon la revendication 1, caractérisé en ce que le système de mesure et de lecture photo-électrique (121) est une caméra de télévision (215), le second moyen (113) étant une unité de déflection de colonnes (233) connue en soi, en ce que cette unité ainsi que l'unité de déflection de lignes (234) usuelle comprend un générateur de dents de scie de colonnes (225) et de lignes (226) correspondant respectivement à l'une et à l'autre unité, la direction (47) de la déflection de colonnes étant perpendiculaire à l'axe fixe (38), en ce que l'unité de commande de canaux (50) est constituée d'un premier (541), second (542) et troisième (543) comparateurs, chacun d'eux comprenant en plus une sortie inversée d'un premier (544), second (545), troisième (546) et quatrième (547) élément- NAND, d'un élément -ET (548), d'un élément -NOR (549) et d'un générateur de valeurs de comparaison (540) ayant une première, quatrième et septième borne de tension selon une suite croissante pour chacun des comparateurs, en ce que le générateur de dents de scie de colonnes (225) ainsi que le générateur de dents de scie de lignes (226) sont synchronisés avec le générateur de cadencement (49) et les première, quatrième et septième bornes de tension du générateur de valeurs comparatives (540) sont reliées selon une suite croissante à la première entrée, chaque fois, du premier (541), du second (542) et du troisième (543) comparateurs, et chacune des secondes entrées du premier (541), du second (542) et du troisième (543) comparateurs sont reliées entre elles et à une connexion dépendante du courant de l'unité de déflection des colonnes (233), et une entrée du premier élément -NAND (544) est reliée à la sortie inversée du premier comparateur (541), et l'autre entrée du premier élément -NAND (544) est reliée à la sortie non-inversée du deuxième comparateur (542), et une entrée du second élément -NAND (545) est reliée à la sortie inversée du second comparateur (542), et la sortie du premier élément -NAND (544) est reliée à la fois à une entrée de l'élément -ET (548) et aux entrées du troisième élément -NAND (546), et la sortie du deuxième élément -NAND (545) est reliée à la fois à l'autre entrée de l'élément -ET (544) et aux entrées du quatrième élément -NAND (547), et la sortie du troisième élément -NAND (546) est reliée à la fois à la première entrée de l'élément -NOR (549) et à la borne de liaison pour la sortie d'intervalle de commutation A (5002), et la sortie du quatrième élément -NAND (547) est reliée à la fois à la seconde entrée de l'élément -NOR (549) et à la borne de liaison pour la sortie d'intervalle de commutation B (5003), et la sortie de l'élément - ET (548) est reliée à la fois à la troisième entrée de l'élément -NOR (549) et à la borne de liaison pour la sortie de l'intervalle de commutation C (5004), et la sortie de l'élément -NOR (549) est reliée à la borne de liaison pour la sortie d'instant de commutation (5001).

9. Dispositif selon la revendication 8, caractérisé en ce que le premier moyen (114) est un circuit-porte à signal analogique (240) qui comprend un canal à signal analogique inhibiteur ayant une entrée (2401) et une sortie (2402) et une entrée d'inhibition (2403), en ce que chez le circuit-porte à signal analogique (240) l'entrée (2401) est reliée à la sortie du signal-vidéo de la caméra de télévision (225), et la sortie (2402) est reliée à la borne de liaison pour une sortie (211) pour le signal-image analogique du système de mesure et de lecture photo-électrique (121), en ce que le premier moyen (114) en combinaison avec l'unité de commande de canaux (50) comprend un quatrième à neuvième (551 à 556) comparateurs, chacun ayant une sortie inversée supplémentaire, un élément -OU (550), un second (557) et troisième (558) élément -ET, et de plus d'autres bornes de tension du générateur de valeurs de comparaison (540), desquelles bornes une seconde et une troisième sont disposées, selon une suite croissante, entre la première et quatrième borne de tension, une cinquième et une sixième entre la quatrième et septième borne de tension, chaque fois symétriquement à la quatrième borne de tension, et de même, symétriquement à celle-ci, une huitième et neuvième borne, en ce que chez le générateur de valeurs comparatives (540), la deuxième borne de tension est reliée à la première entrée du quatrième comparateur (551), la troisième borne de tension est reliée à la première entrée du cinquième comparateur (552), la cinquième borne de tension est reliée à la première entrée du sixième comparateur (553), la sixième borne de tension est reliée à la première entrée du septième comparateur (554), la huitième borne de tension est reliée à la première entrée du huitième comparateur (555), la neuvième borne de tension est reliée à la première entrée du neuvième comparateur (556), et chaque deuxième entrée du quatrième (551), du cinquième (552), du sixième (553) et septième (554) comparateur est reliée à la connexion dépendante du courant de l'unité de déflection des colonnes (233), et chacune des deuxièmes entrées du huitième (555) et neuvième (556) comparateur est reliée à la connexion du courant de l'unité de déflection de lignes (234), et chez le deuxième élément -ET (557) une entrée et reliée à la sortie inversée du quatrième comparateur (551), l'autre entrée est reliée à la sortie non-inversée du cinquième comparateur (552), et la sortie est reliée à la première entrée de l'élément -OU (550), et en ce que chez le troisième élément -ET (558) une entrée est reliée à la sortie inversée du sixième comparateur (553), l'autre entrée est reliée à la sortie non-inversée du septième comparateur (554), et la sortie est reliée à la deuxième entrée de l'élément -OU (550), chez le quatrième élément -ET (559) une entrée est reliée à la sortie inversée du huitième comparateur (555), l'autre entrée est reliée à la sortie non-inversée du neuvième comparateur (556) et la sortie est reliée à la troisième entrée de l'élément -OU (550) et la sortie de l'élément -OU (550) est reliée à l'entrée de l'inhibition (2403) du circuit-porte à signal analogique (240).

10. Dispositif selon la revendication 1, caractérisé en ce que les repères d'ajustement du second objet (2) ont la forme d'une paire d'ouvertures (7, 8) de gabarit identiques entre elles, lesquelles ouvertures sont situées symétriquement par rapport à un axe (40) de paire d'ouvertures du gabarit, et sont séparées par un filet intermédiaire opaque, en ce que cette paire d'ouvertures (7, 8) de gabarit est projetée sur les repères (4, 5) d'ajustement du premier objet (1) et avec ce dernier sur le plan de lecture (100) du système de mesure et de lecture photo-électrique (121), de telle sorte que l'axe (40) de la paire d'ouvertures du gabarit et l'axe fixe (38) sont sensiblement parallèles, que dans la direction de l'axe (40) de la paire d'ouvertures de gabarit la reproduction des images (7', 8') des ouvertures de gabarit sur le plan de lecture (100) est plus grande que l'étendue des lecteurs d'image (115, 116), et que perpendiculairement à l'axe (40) de la paire d'ouvertures de gabarit ladite reproduction est plus petite que l'étendue des lecteurs d'image (115, 116), en ce que sont prévus un premier organe de réglage (26) pour l'ajustement du premier objet (1) et un second organe de réglage (27) pour l'ajustement du second objet (2) par rapport au système de mesure et de lecture photo-électrique (121) et un aiguillage de mode d'entraînement (25) pouvant être commandé, dont les deux sorties sont reliées respectivement au premier (26) et au second (27) organes de réglage pour la transmission de signaux de commande, l'entrée-signal desdits organes de réglage étant reliée à la sortie (8005) de l'unité de calcul, et la sortie-signal desdits organes de réglage étant reliée à un agencement de sélection de mode de fonction (24).

11. Dispositif selon la revendication 10, caractérisé en ce que l'unité de traitement séquentiel du signal-image (60) et l'unité de calcul (80) sont installées en vue de reconnaître la structure et de déterminer la position d'éléments d'image sombres, en ce que l'unité de traitement séquentiel du signal-image (60) contient un comparateur de signal-image (620), un régleur du niveau d'image (621), un élément -NAND servant de circuit inverseur (622), un élément -NAND servant de commutateur (623), un élément -ET servant de porte (624), un élément -ET servant de comparateur de cadencement (625) et un élément -OU (626), en ce que chez le comparateur une entrée est reliée au régleur de niveau d'image (621), l'autre entrée est reliée à la sortie (211) pour le signal-image analogique du dispositif de mesure et de lecture photo-électrique (121), et la sortie est reliée à la fois à une entrée du circuit inverseur (622) et à une entrée de la porte (624), et chez le commutateur (623) l'entrée est reliée à la fois à l'agencement de sélection du mode de fonction (24) et à l'autre entrée de la porte (624), et la sortie est reliée à l'autre entrée du circuit inverseur (622), et chez l'élément -OU (626) une entrée est reliée à la sortie du circuit inverseur (622), l'autre entrée est reliée à la sortie de la porte (624), et la sortie est reliée à la fois à une première entrée (8001) de l'unité de calcul pour le signal-image binaire et à une entrée du comparateur de cadencement (625), et chez le comparateur de cadencement (625) l'autre entrée est reliée au générateur de cadencement (49), et la sortie est reliée à une deuxième entrée (8002) de l'unité de calcul pour la cadence du signal-image, de telle sorte qu'en position de commutation pour l'ajustement du premier objet (1) relativement au second objet (2), la sortie du comparateur du signal-image (620) est reliée directement à la première entrée (8001) de l'unité de calcul et qu'en position de commutation pour l'ajustement du second objet (2) relativement au système de mesure et de lecture photo-électrique (121) la sortie du comparateur de signal-image (620) est reliée à la première entrée (8001) de l'unité de calcul *via* le circuit inverseur (622).

0 051 567

Fig.1

Fig. 2

Fig. 3a

Fig. 3b

Fig. 3c

Fig.4

Fig.5

Fig.6

Fig.7

Fig.8

Fig.9